(19) Europäisches Patentamt
European Patent Office
Office européen des brevets

(11) **EP 3 380 857 B1**

(12) **EUROPÄISCHE PATENTSCHRIFT**

(45) Veröffentlichungstag und Bekanntmachung des Hinweises auf die Patenterteilung:
**28.08.2019 Patentblatt 2019/35**

(21) Anmeldenummer: **16819425.6**

(22) Anmeldetag: **21.11.2016**

(51) Int Cl.:
**G01R 33/36** *(2006.01)* **G01R 33/60** *(2006.01)*
**G01R 33/30** *(2006.01)* **G01R 33/34** *(2006.01)*

(86) Internationale Anmeldenummer:
**PCT/DE2016/100540**

(87) Internationale Veröffentlichungsnummer:
**WO 2017/088852 (01.06.2017 Gazette 2017/22)**

(54) **VORRICHTUNG UND VERFAHREN ZUR ERZEUGUNG UND DETEKTION EINER TRANSIENTEN MAGNETISIERUNG EINER PROBE**

DEVICE AND METHOD FOR GENERATING AND DETECTING A TRANSIENT MAGNETIZATION OF A SAMPLE

DISPOSITIF ET PROCÉDÉ POUR GÉNÉRER ET DÉTECTER UNE AIMANTATION TRANSITOIRE D'UN ÉCHANTILLON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.11.2015 DE 102015120644**

(43) Veröffentlichungstag der Anmeldung:
**03.10.2018 Patentblatt 2018/40**

(73) Patentinhaber: **Helmholtz-Zentrum Berlin für Materialien
und Energie GmbH
14109 Berlin (DE)**

(72) Erfinder:
• **ANDERS, Jens
89081 Ulm (DE)**
• **LIPS, Klaus
10781 Berlin (DE)**

(56) Entgegenhaltungen:
**US-A1- 2014 091 802**

• **JENS ANDERS ET AL: "K-band single-chip electron spin resonance detector", JOURNAL OF MAGNETIC RESONANCE., Bd. 217, 18. Februar 2012 (2012-02-18), Seiten 19-26, XP055354363, US ISSN: 1090-7807, DOI: 10.1016/j.jmr.2012.02.003**

**Beschreibung**

Technisches Gebiet

Die Erfindung betrifft eine Vorrichtung und ein Verfahren zur Erzeugung und Detektion einer transienten Magnetisierung einer Probe, wie sie zum Beispiel in der Elektronenspinresonanz-Spektroskopie und der Kernspinresonanzspektroskopie zur Anwendung kommt, die unter anderem in der Experimentalphysik, der Medizintechnik, den Materialwissenschaften oder den Geowissenschaften Einsatz finden.

Stand der Technik

Bei der Elektronenspinresonanz-Spektroskopie (ESR, electron spin resonance spectroscopy auch als EPR, electron paramagnetic resonance bezeichnet) und der Kernspinresonanzspektroskopie (NMR, nuclear magnetic resonance spectroscopy) werden Proben in einem statisch homogenen, statisch inhomogenen oder dynamischen (gepulst inhomogen) Magnetfeld, üblicherweise als $B_0$ bezeichnet, zusätzlichen hochfrequenten, elektromagnetischen Wechselfeldern (in der ESR zumeist im Mikrowellenbereich zwischen 1 und 263 GHz), üblicherweise als $B_1$ bezeichnet, ausgesetzt.

Durch die Einkopplung von Wechselfeldern ($B_1$) geeigneter Frequenz und Polarisation werden Übergänge zwischen den Energieniveaus diskreter Spinzustände der Atomkern- und/oder Elektronenkonfiguration einer Probe induziert, die ihrerseits zu Absorptionsvorgängen im Wechselfeld führen, welche sich detektieren lassen. Aus den detektierten Absorptionsvorgängen lassen sich verschiedene stoffanalytische Informationen der Probe bestimmen. Das linear polarisierte Feld $B_1$ ist dabei üblicherweise senkrecht zu $B_0$ orientiert.

Proben, die einer Charakterisierung durch ESR- oder NMR- Experimente zugänglich sind, sind demnach alle magnetisierbaren Proben, d.h. paramagnetische Proben (ungepaarte Elektronen, ESR) oder Proben mit Atomkernen mit "Nettokernspin" aufgrund ungerader Anzahl an Nukleonen (NMR). Die Proben können sowohl flüssig, fest oder auch gasförmig sein. Im Folgenden ist der Begriff "Probe" immer verwendet im Sinne einer magnetisierbaren Probe, wie vorstehend eingeführt.

Zur eindeutigen Charakterisierung der Energiedifferenzen der Spinzustände (Resonanzenergie) und der zugehörigen Spektrallinien, den spektralen Komponenten, kann wahlweise das gyromagnetische Verhältnis $\gamma$ oder der sogenannte $g$-Faktor, auch Landé-Faktor genannt, gemäß

$\Delta E = h \cdot \omega = \gamma \cdot B_0 \cdot h = g \cdot \mu_B \cdot B_0$ ($h$ = Plancksches Wirkungsquantum, $\mu_B$ = Bohrsches Magneton, $\omega$ = Kreisfrequenz der Präzession des Magnetfeldes), benutzt werden. Die $g$-Faktoren sind dabei nicht unbedingt isotrop und müssen gegebenenfalls als Tensoren behandelt werden. Die spektralen Komponenten hängen dabei nicht nur von den $g$-Faktoren ab, sondern z.B. auch von der Kopplung mit benachbarten Kernspins und Elektronenspins. Dabei kann z.B. durch mikroskopische magnetische Wechselwirkungen innerhalb der Probe die Energiedifferenz von Spinzuständen weiter modifiziert sein, was sich dann durch den sogenannten vollständigen Hamilton Wechselwirkungsoperator, beschreiben lässt. Im Folgenden wird dieser komplexe Zusammenhang einfach mit dem Resonanzfall der zu betrachtenden Spinzustände umschrieben und die jeweiligen Wechselwirkungen nicht weiter erläutert. Im Resonanzfall entspricht die Frequenz der sogenannten Lamorfrequenz.

Im Resonanzfall der Anregung durch das $B_1$-Feld treten sogenannte Rabi-Oszillationen auf. Dies sind Oszillationen in einem quantenmechanischen Zwei- oder Mehrniveau-System, welches mit einer externen periodischen Kraft (z. B. ein oszillierendes Magnetfeld) wechselwirkt. Liegt die Anregungsfrequenz nahe der Resonanzfrequenz der Übergänge, so oszilliert die Besetzung der Zustände mit einer Frequenz, die auch als Rabi-Frequenz bezeichnet wird.

ESR- als auch NMR-Experimente werden üblicherweise bei der bzw. möglichst nahe der Resonanzfrequenz durchgeführt, wie es auch im Folgenden, wenn nicht anders vermerkt, vorausgesetzt wird.

In den sogenannten "Dauerstrich"- (englisch: continuous wave) ESR- oder NMR-Experimenten wird bei kontinuierlicher Einstrahlung von magnetischen Wechselfeldern ($B_1$) und eventueller gleichzeitiger Änderung der Stärke des Magnetfeldes ($B_0$) die Energie bestimmt, die erlaubten oder schwach verbotenen Übergängen zwischen verschiedenen Energieniveaus von Spinensembles entspricht (Resonanzfall).

In sogenannten gepulsten ESR- oder NMR-Experimenten wird mit einem starken elektromagnetischen Puls ($B_1$) (transientes Magnetfeld) eine Präzessionsbewegung der Orientierung der makroskopischen Magnetisierung der Probe um die Richtung des effektiven Magnetfelds in der Probe angeregt und ihr Relaxationsprozess sowie die Präzessionsfrequenz detektiert, bei statischem oder auch dynamischen (zeitlich und oder örtlich veränderlichen) Magnetfeld $B_0$. Der Relaxationsprozess wird auch als transiente (zeitlich veränderliche) Magnetisierung bezeichnet bzw. ein sogenanntes transientes Signal wird detektiert. Die transiente Magnetisierung ist in ihrer zeitlichen Dauer begrenzt durch die Spin-Gitter-Relaxationszeit ($T_1$) und die Spin-Spin-Relaxationszeit ($T_2$). Für ESR-Experimente liegen diese Zeiten im Sub-Nano- bis Sekundenbereich, die üblichen Messfenster liegen aber zwischen 1 ns bis 1 ms.

Zur Vermeidung von Relaxationsprozessen während der Anregung, wodurch die Modellierung des Experiments deutlich vereinfacht wird, muss die Zeitspanne, in der das transiente Magnetfeld ($B_1(t,\omega)$) anliegt, kurz gegenüber den Relaxationszeiten sein. Da Relaxationszeiten einer Probe im ESR-Fall im Sub-Nanosekundenbereich liegen können, sind transiente Magnetfelder mit Zeitdauern im Sub-Nanosekundenbereich (< 1 ns) für bestimmte Proben erforderlich. Die Zeitdauer der transienten Magnetisierung ist dabei über den Zusammenhang zur Spin-Gitter-Relaxationszeit ($T_1$) und Spin-Spin-Relaxationszeit ($T_2$) abhängig von der Probe.

Das Magnetfeld $B_0$ kann bei gepulsten ESR- oder NMR-Experimenten ein über den Ort linear veränderliches Magnetfeld (Gradientenfeld) sein, wie es z.B. in bildgebenden Verfahren, die auf Magnetresonanz beruhen, eingesetzt wird.

Die physikalischen Grundlagen werden im Folgenden näher ausgeführt.

In der klassischen Mechanik erfährt ein magnetisches Dipolmoment $\vec{\mu}$ in einem magnetischen Feld $\vec{B}$, ein Drehmoment $\vec{\tau}$ gemäß $\vec{\tau} = \vec{\mu} \times \vec{B}$. Demgemäß kann im Prinzip jedwede makroskopische Magnetisierung $\vec{M}$ in Form eines angelegten, äußeren Magnetfeldes beeinflusst werden, weil sie aus einem kombinierten Effekt mikroskopischer magnetischer Momente resultiert. ESR- oder NMR-Experimente sind hierfür bekannte Beispiele, in denen ein externes Magnetfeld angelegt wird und eine Probenmagnetisierung $\vec{M_s}$, die geknüpft ist an die Spins von Elektronen bzw. Atomkernen und deren Wechselwirkung, bestimmt wird. Quantenmechanische Betrachtungen zeigen, dass der Spin eines Teilchens nicht nur geknüpft ist an das magnetische Dipolmoment $\vec{\mu}$, sondern auch an den Bahndrehimpuls $\vec{L}$, welche miteinander in Beziehung stehen gemäß

$\vec{\mu} = \gamma \cdot \vec{L}$, mit dem gyromagnetischen Verhältnis $\gamma$, welches spezifisch ist für ein Material einer Probe. Im einfachsten zu betrachtenden Fall von Spin ½ Teilchen und der Annahme, dass keine Interaktion zwischen den Spins vorliegt, kann die makroskopische Magnetisierung, die auf den Spins basiert, innerhalb eines angelegten magnetischen Feldes $\vec{B}$, beschrieben werden mit einer vereinfachten Bloch-Gleichung, d.h. einer Bloch-Funktion ohne Relaxationsterme gemäß

$$\frac{d\vec{M_s}}{dt} = -\gamma \cdot \left(\vec{M_s} \times \vec{B}\right). \qquad (0.1)$$

Aus (0.1) folgt, dass eine spinbasierte Magnetisierung $M_s$, welche einen Winkel einschließt mit einem magnetischen Feld $B_0$, eine Präzessionsbewegung um die Achse des $B_0$-Feldes ausführt, mit einer Winkelgeschwindigkeit, die der sogenannten Larmorfrequenz $\omega_L = -\gamma \cdot B_0$ entspricht. Eine Auslenkung der Magnetisierung $M_s$ kann z.B. durch ein angelegtes, zeitlich veränderliches Magnetfeld $B_1$, welches senkrecht zu $B_0$ orientiert ist und eine Frequenz $\omega_L$ aufweist, erfolgen, so dass $M_s$ um die Achse des $B_1$-Feldes rotiert. Da dieser Fall, in dem $\vec{M_s}$ nicht parallel zu $\vec{B_0}$ orientiert ist, einem Ungleichgewichtszustand entspricht, bewirken Relaxationsmechanismen, dass jegliche transversale Magnetisierung $M_{s\perp}$ zu Null abklingt und die longitudinale Magnetisierung $M_{s\parallel}$ in der Richtung von $B_0$ wiederhergestellt wird, was dem Gleichgewichtszustand $M_{s0}$ entspricht. Diesem Umstand kann mit der Einführung der Relaxationszeiten in die Bloch-Gleichung gemäß (0.1) Rechnung getragen werden mit

$$\frac{d\vec{M_s}}{dt} = -\gamma \cdot \left(\vec{M_s} \times \vec{B}\right) + \frac{1}{T_2} \cdot \vec{M_{s\perp}} + \frac{M_{s\parallel} - M_{s0}}{T_1} \vec{e}_\parallel \qquad (0.2)$$

($t$ = Zeit, $\vec{e}_\parallel$ = Einheitsvektor in Richtung des $B_0$-Feldes).

In dem **Aufsatz 1** von M. Prisner et al. (Pulsed EPR Spectroscopy: Biological Applications, Annual Review of Physical Chemistry 52, 2001, S. 279-313) ist eine Übersicht über gepulste ESR-Experimente an biologischen Proben gegeben und in dem **Aufsatz 2** von R. Benn und H. Günther (Modern Pulse Methods in High-Resolution NMR Spectroscopy, Angewandte Chemie International Edition, Vol. 22, 1983, S. 350 - 380) über gepulste NMR-Experimente.

In der DE 42 23 909 C2 ist eine Vorrichtung zum Messen magnetischer Resonanz zum Einsatz in der Medizintechnik offenbart, in der eine Solenoid-Spule zur Erzeugung des Magnetfeldes $B_0$ dient. Eine als Sende- oder Empfangseinrichtung genutzte Anordnung besteht aus einem Spaltringresonator. Weiterhin ist eine Koppeleinrichtung zur Detektion eines Resonanzsignals vorgesehen, realisiert durch eine Koppelschleife. Weitere Schaltungseinheiten vervollständigen die Vorrichtung.

Eine als Elektronenspinresonanz-Impulsspektrometer bezeichnete Vorrichtung ist in der DE 44 12 064 A1 offenbart. Sie verfügt über einen ersten Mikrowellenoszillator zum Erzeugen von Abtastsignalen (Messsignalen), $B_1$, und einem zweiten Mikrowellenoszillator zum Erzeugen von Hilfssignalen einer niedrigeren Mikrowellenfrequenz. Zusätzlich sind ein erster Mischer und ein Pulsformkanal zur Erzeugung von Mischsignalen mit einer für Elektronenspinresonanz-Impulsexperimenten geeigneten Pulslänge und ein Resonator zur Detektion vorgesehen.

In der US 2014/0210473 A1 ist ein Elektronenspinresonanz-Spektrometer offenbart, das mit einer Tastspitze als Sende- und Empfangsvorrichtung ausgestattet ist. Dabei wird das Anregungsfeld ($B_1$) für die Sendevorrichtung außerhalb von dieser erzeugt und mit geeigneten Mitteln in die Tastspitze geleitet. Das Spektrometer kann auch im gepulsten Modus betrieben werden, wobei die Pulse und die Erfassung der Signale von einer zeitlichen Dauer sind, die jedoch keine zeitaufgelöste Erfassung einer transienten Magnetisierung einer Probe ermöglichen.

Eine Herausforderung für ESR- oder NMR-Experimente ist die Realisierung als sogenannte "single chip" (Einchipprozessor) Ausführungen mit integrierter Schaltungstechnik, die die Anwendung der Experimente im Vergleich zu herkömmlichen Ausführungen nutzerfreundlich, in Miniaturisierung und kostengünstig gestalten.

In dem **Aufsatz 3** von T. Yalcin und G. Boero (Single-chip detector for electron spin resonance spectroscopy, Review of Scientific Instruments 79, 2008, S. 094105-1 - 6) wird ein "single-chip"-ESR-Spektrometer offenbart, welches im Dauerstrichmodus arbeitet. Die wesentlichen Komponenten des Detektors, der in sogenannter CMOS-(complementary metal-oxide-semiconductor, "komplimentärer Metall-Oxid-Halbleiter") Technologie ausgeführt ist, sind zwei spannungsgesteuerte LC-Oszillatoren, auch VCO (englisch voltage-controlled oscillator) genannt, ein Mischer, ein Filterverstärker, zwei Frequenzteiler und Signalkonditionierer sowie eine Phasenregelschleife als Detektoren. Zusätzlich müssen Mittel zur Erzeugung des Magnetfeldes $B_0$ und zur Verschaltung des Spektrometers bereitgestellt werden.

Eine auf einem Chip angeordnete Vorrichtung, die in der WO 2005/073695 A1 offenbart ist, umfasst Mittel zur Erzeugung eines Magnetfeldes vorbestimmter Richtung, eine Sendevorrichtung, die u.a. eine Leiterbahn umfasst und eine Empfangsvorrichtung, die einen den Magnetwiderstand erfassenden Sensor enthält.

In der US 2014/0091802 A1 ist ein single chip ESR-Spektrometer offenbart, das gepulst und im Dauerstrichmodus betrieben und u.a. in CMOS-Technologie ausgeführt werden kann. Es weist ein Mittel zur Erzeugung eines Magnetfelds vorbestimmter Richtung auf, ferner eine Sendevorrichtung, die aus einem LC-VCO und einem Verstärker besteht, an die ein Pulsgenerator gekoppelt ist und die einen Resonator speist. Derselbe oder ein weiterer Resonator ist hier als Empfangsvorrichtung zugeschaltet. Die Empfangsvorrichtung besteht weiterhin aus einem Verstärker, einem Mischer und einem Basisbandverstärker.

In der US 2014/0097842 A1 ist ein Verfahren zur Bestimmung der magnetischen Resonanz oder transienten Magnetisierung einer Probe, das mit der Vorrichtung aus der US 2014/0091802 A1 durchgeführt wird, offenbart. Es beinhaltet die Schritte:

- Generierung eines oszillierenden Abtastsignals mit der integrierten Oszillator-Schaltungsanordnung,
- Verstärkung des oszillierenden Abtastsignals mit dem integrierten Verstärker,
- Empfangen eines ESR-Signals einer Probe mit dem integrierten Empfänger-Verstärker-Schaltkreis,
- Verstärken eines ESR-Signals einer Probe, mit dem integrierten Empfänger-Verstärker-Schaltkreis,
- Abwärtswandlung des verstärkten ESR-Signals mit dem integrierten Mischer-Schaltkreis, zum Erhalt eines Basisbandsignals und
- Verstärkung des Basisbandsignals mit dem integrierten Basisbandverstärker-Schaltkreis, wobei
- alle Schalteinheiten auf einem Chip integriert sind.

Ein Nachteil der aus dem Stand der Technik bekannten resonatorbasierten ESR- und NMR- Spektrometer ist, dass in diesen zum Schutz eines rauscharmen Vorverstärkers dieser während des Pulses (des transienten Magnetfeldes) vom Resonator abgekoppelt (geblankt) werden muss, z.B. über einen zeitlich begrenzten Schutzpuls, so dass eine Detektion der Magnetisierung erst nach dem (Schutz-)Puls möglich wird. Dies basiert darauf, dass die Konversion im Resonator von elektromagnetischer Energie in $B$-Felder hohe elektrische Leistungen (> 100 W bzw. bei Mikroresonatoren weniger) erfordert, die in den Resonator geschickt werden. Diese große elektrische Leistung würde den Vorverstärker bzw. die Ausleseelektronik sättigen bzw. sogar zerstören, falls nicht abgekoppelt.

Aufgabenstellung

Die Aufgabe der vorliegenden Erfindung ist es, eine Vorrichtung und ein Verfahren zur Erzeugung und Detektion einer transienten Magnetisierung einer Probe anzugeben, mit denen transiente Magnetisierungen zeitaufgelöst erfasst werden können und die Vorrichtung im Vergleich mit dem Stand der Technik vereinfacht aufgebaut ist, energieeffizient arbeitet und eine Detektion der transienten Magnetisierung während der transienten Anregung ermöglicht.

Die Aufgabe wird durch die Ansprüche 1 und 13 gelöst. Vorteilhafte Ausführungen sind Gegenstand der Unteransprüche.

Das Mittel zur Erzeugung eines Magnetfelds vorbestimmter Richtung in der erfindungsgemäßen Vorrichtung ist zum Beispiel durch supraleitende Magnete oder Elektromagnete beliebiger Ausführung oder Permanentmagnete realisiert. Das erzeugte Magnetfeld ist statisch und entspricht dem Magnetfeld $B_0$, das zur Magnetisierung einer zur Magnetisierung geeigneten Probe dient. Das Magnetfeld kann dabei von beliebiger Stärke sein, solange die Frequenz des anregenden $B_1$-Magnetfelds entsprechend den Resonanzbedingungen gewählt wird.

Als Proben kommen feste, gasförmige und flüssige Proben in Betracht. Flüssige Proben können z.B. in Glaskapillaren auf planare Ausführungen (z.B. in CMOS-Technologie) gelegt werden. Bei niedrigeren Frequenzen von $B_1$ bis in das sogenannte X-Band (ca. 10 GHz) können die Spulen der LC-Oszillatoren auch als Volumenspulen realisiert werden, in die die Kapillaren mit flüssigen Proben eingebracht werden können oder aber mit (mikro-) fluidischen Systemen zum Transport von Proben in den Detektor kombiniert werden.

Der Probenort ist ein Ort in der Vorrichtung, an dem die Probe angeordnet wird und an dem sowohl das Magnetfeld ($B_0$) als auch, gegebenenfalls, das transiente Magnetfeld ($B_1$) anliegen. Es können hier Mittel zur Befestigung und Aufbewahrung der Probe vorgesehen sein.

Die Sendevorrichtung, die zugleich auch als Empfangsvorrichtung dient, besteht aus einem LC-Oszillator, dessen Oszillationsfrequenz vom Wert eines induktiven Elements des LC-Oszillators abhängt. Dies können z. B. Hartley-, Colpitts- oder Armstrong-Oszillatoren oder LC-Tank-Oszillatoren sein. Diese LC-Oszillatoren können sowohl als LC-Oszillatoren mit fester Arbeitsfrequenz ausgeführt werden als auch durch die Verwendung von abstimmbaren (elektrisch oder mechanisch) Induktivitäten und/oder Kapazitäten für ein ganzes Frequenzband entworfen sein.

Die einzelnen Schaltungselemente der LC-Oszillatoren können dabei als integrierter Schaltkreis oder miniaturisiert ausgeführt sein (z.B.in CMOS-Technologie), wobei diese Ausführungen keine Voraussetzung für die Funktion der Vorrichtung ist.

Der LC-Oszillator dient hier insofern als Sendevorrichtung, als er das zusätzliche, transiente Magnetfeld, das senkrecht zu $B_0$ orientiert ist, erzeugt. Die Anordnung des LC-Oszillators ist dabei erfindungsgemäß jedoch so gewählt, dass sich die Probe bzw. der Probenort im Nahfeld des LC-Oszillators befindet.

Das Nahfeld ist hier für die erfindungsgemäße Vorrichtung und das erfindungsgemäße Verfahren als das Feld des LC-Oszillators aufzufassen, in dem die Rotation des $B_1$-Feldes und - wegen div $B = 0$ - auch das gesamte $B_1$-Feld maßgeblich über die Stromdichte $J$ im induktiven Element bestimmt ist mit rot $\vec{B} \approx \mu_0 \cdot \vec{J} (\mu_0$ = magnetische Feldkonstante). Im Gegensatz dazu findet im Fernfeld eine Wellenausbreitung statt und das $E_1$- und $E_1$-Feld (elektrische Feld) erzeugen sich gegenseitig mit rot $\vec{B_1} \approx \mu_0 \cdot \varepsilon_0 \partial \vec{E_1} / \partial t, \varepsilon_0$ = elektrische Feldkonstante, $t$ = Zeit. Für das Nahfeld gilt mithin, dass das $B_1$-Feld weitestgehend unabhängig vom $E_1$-Feld erzeugt werden kann, da im Bereich des Nahfelds noch keine Welle vorliegt. Durch diesen Umstand ist das $E_1$-Feld vereinfacht optimierbar bzw. kann dieses gering gehalten werden. Geringe $E_1$-Felder minimieren elektrische Verluste in der Probe sowie den Verlust der durch die Erwärmung der Probe entsteht, was ein Vorteil der erfindungsgemäßen Vorrichtung ist.

Ein transientes Magnetfeld $B_1(t,\omega)$ (d.h ein Magnetfeld mit zeitlich begrenzter veränderter Frequenz) im LC-Oszillator kann durch geeignete Einspeisung von Spannungen in spannungsgesteuerte Kapazitäten (Varaktoren) erzeugt werden. Die Form der Änderung ist dabei nicht beschränkt und kann z.B. stufenförmig, sägezahnförmig oder als Spitze ausgebildet sein.

Das transiente Magnetfeld $B_1(t,\omega)$ - als Funktion der Zeit und Frequenz - ist auf eine Zeitspanne verkürzbar, die um so viel kürzer als die Relaxationszeiten der Probe ist, dass Relaxationseffekte während des Pulses vernachlässigbar sind. Da Relaxationszeiten einer Probe im ESR-Fall im Sub-Nanosekundenbereich liegen können, sind transiente Magnetfelder mit Zeitdauern im Sub-Nanosekundenbereich (< 1 ns) für bestimmte Proben erforderlich.

In der erfindungsgemäßen Lösung besteht darüber hinaus vorteilhaft die Möglichkeit zur Detektion einer transienten Magnetisierung einer Probe während des Anliegens des transienten Magnetfeldes, da, anders als im Fall der aus dem Stand der Technik bekannten resonatorbasierten ESR-Detektoren, die Detektionselektronik nicht vor den starken elektromagnetischen Anregungspulsen geschützt werden muss. Dies beruht auf der Tatsache, dass bei der Benutzung eines LC-Oszillators als Sende- und Empfangsvorrichtung das $B_1$-Feld zur Erregung der Magnetisierung in der Probe, im Oszillator selbst, durch den Strom in der Spule erzeugt wird. Dabei reichen aufgrund der sehr guten Umsetzung von Strom in ein $B_1$-Feld (Biot-Savart-Gesetz, Nahfeld) die im Betrieb auftretenden Ströme (je nach Größe der Spule liegen diese bei im einstelligen bis dreistelligen mA-Bereich, insbesondere zwischen 10 mA bis 200 mA) für $B_1$-Felder, die größer als 1 mT sind aus, die wiederum die benötigten kurzen Pulse ermöglichen (10 mT entspricht etwa einer Pulslänge von 1 ns). Der Oszillator wird dabei im Betrieb zur Erzeugung üblicher Feldstärken nicht beschädigt oder irreversibel verändert. Die Zeitauflösung und die Empfindlichkeit der Messungen werden verbessert. Dies erfolgt hauptsächlich dadurch, dass die Messung eher (noch während der Anregung/des Pulses) und somit vor dem Einsetzen signifikanter Relaxationseffekte beginnen kann.

Die Dauer, Anzahl und Form der transienten Magnetfelder wird entsprechend den Anforderungen der Probe und der gewünschten Manipulation des Spinensembles in der Probe gewählt.

Im einfachsten Fall ist die Pulslänge probenabhängig so zu wählen, dass die Magnetisierung in der Probe um $\theta = 90°$ gekippt wird ($\theta = \gamma \cdot B_1 \cdot \tau_{puls}$, $\tau_{puls}$ = Zeitdauer des Anlegens des resonanten $B_1$-Feldes, $\gamma$ = gyromagnetisches Verhältnis), da so die transversale Magnetisierung maximiert wird. Diese wird auch durch den erfindungsgemäßen LC-Oszillator detektiert. Generell lässt sich aber auch jeder andere Drehwinkel einstellen bzw. benutzen, wenn dies von Vorteil für das jeweilige ausgewählte Experiment ist.

Die Stärke des $B_1$-Feldes kann mit der erfindungsgemäßen Vorrichtung ausreichend groß gemacht werden, um z.B. 90°-Pulslängen ($\theta = 90°$) mit $\tau_{puls}$ im Sub-Nanosekunden Bereich zu erzeugen, so dass hierdurch in Kombination mit der Möglichkeit zur Detektion während der Anregung auch sogenannte Rabi-Oszillationen für Proben mit kurzen $T_2$-Relaxationszeiten direkt gemessen werden können. Die Stärke des $B_1$-Feldes wird dabei durch geeignete Wahl der Oszillatorversorgungsspannung bzw. des Oszillatorruhestroms sowie durch geeignete Wahl der Spuleninduktivität im Verhältnis zur frequenzbestimmenden Kapazität eingestellt.

Die an der spannungsgesteuerten Induktivität oder Kapazität eingespeisten Spannungen liegen in Form von zeitabhängigen Wellenformen vor. Die zeitabhängigen Wellenformen sind dadurch charakterisiert, dass sie eine Änderung in der Spannungsstärke von begrenzter Zeitdauer beinhalten. Die Änderungen in der Spannung bewirken das transiente Magnetfeld $B_1(t, \omega)$ im spannungsgesteuerten LC-Oszillator mit geänderter Frequenz. Eine Erhöhung bzw. Erniedrigung der Spannung kann dabei je nach Realisierung des Varaktors entweder zu einer Frequenzerniedrigung oder zu einer Frequenzerhöhung führen. Der Vorteil bei einem Betrieb des LC-Oszillators bei niedrigerer Oszillationsfrequenz als der Resonanzfrequenz ist, dass der LC-Oszillator insgesamt für eine niedrigere Oszillationsfrequenz entworfen werden kann. Der Vorteil bei einem Betrieb des LC-Oszillators bei höherer Oszillationsfrequenz als der Resonanzfrequenz ist, dass sich die Signaldemodulation vereinfacht. Die Form der Änderung ist dabei ebenfalls nicht beschränkt und kann - wie bereits erwähnt - z.B. stufenförmig, sägezahnförmig oder als Spitze ausgebildet sein. Die Wahl der Frequenzen richtet sich nach der erforderlichen Leistungsdichte bei den Resonanzfrequenzen der Probe. Die Dauer, Anzahl und Form der zeitabhängigen Wellenformen wird entsprechend den durch die Probe vorbestimmten Anforderungen an das transiente Magnetfeld gewählt (siehe oben).

Zur Erzeugung von transienten Magnetfeldern mit bestimmter Phase kann der LC-Resonator darüber hinaus in eine Phasenregelschleife mit umschaltbarer Referenzfrequenz und Phase realisiert werden, wie es einem Ausführungsbeispiel entspricht.

Da durch die Spule des LC-Oszillators, sobald dieser eingeschaltet ist, ein Strom fließt, wird auch direkt ein $B_1$-Feld erzeugt. Die Amplitude des $B_1$-Feldes braucht jedoch eine gewisse Zeit, bis sie einen gewünschten Wert erreicht hat. Daher ist es vorteilhaft, den LC-Oszillator von einer ersten Frequenz, die von der Resonanzfrequenz weit genug entfernt liegt um keine Anregung in der Probe zu bewirken, nach einer zweiten Frequenz (Resonanzfrequenz) zu schalten, da so ein Einschwingvorgang auf vernachlässigbare, extrem kurze Änderungen in der Amplitude reduziert wird. Der LC-Oszillator sollte dabei generell für die Zeiten, in denen keine Anregung der Probenmagnetisierung erfolgen soll, konstant bei der ersten Frequenz betrieben werden, um Einschwingvorgänge zu vermeiden bzw. stark zu reduzieren.

Eine erste zeitabhängige Wellenform wird als Steuerspannung dem LC-Oszillator zugeführt.

Eine zweite, ebenfalls zeitabhängige Wellenform, die zur Einstellung der Hüllkurve der transienten Magnetisierung des LC-Oszillators genügt, wird in die Versorgungsspannung des LC-Oszillators, gegebenenfalls unter Zuhilfenahme weiterer Schaltungselemente, eingespeist.

Das transiente Magnetfeld $B_1(t, \omega)$, das so vom LC-Oszillator generiert wird, genügt in Frequenz und Einhüllender mindestens dazu, eine Magnetisierung einer Probe im $B_0$-Feld aus ihrer Gleichgewichtslage auszulenken. Dies gilt z. B. für Experimente zur Detektion von Rabi-Oszillationen, Spinechos oder bei einfachen FID (free induction decay) Messungen, für die einzelne Pulse genügen.

Als Mittel zur Ansteuerung des LC-Oszillators dienen Mittel zur Erzeugung der ersten und zweiten zeitabhängigen Wellenform, die in den LC-Oszillator eingespeist werden. Diese Mittel sind zum Beispiel Digital-Analog-Wandler, gesteuert durch Personal Computer, FPGA (Field Programmable Gate Array - programmierbare Logik-Gatter-Anordnung), Mikrocontroller, "Arbitrary Waveform" Generatoren (Arbiträrgeneratoren) oder für einfache Rampen- oder Puls-Funktionsgeneratoren.

Simultan zu dem auf die Probe einwirkenden transienten Magnetfeld $B_1(t, \omega)$ und/oder in der zeitlichen Folge auf dieses wird die zeitabhängige Änderung der Magnetisierung (Transiente) der Probe detektiert. Die Änderung der Magnetisierung der Probe bewirkt eine Änderung im induktiven Element des LC-Oszillators, die sich als Änderung der Oszillationsfrequenz und/oder Oszillationsamplitude des LC-Oszillators in einer Ausgangsspannung desselben detektieren lässt. Dazu wird die Ausgangsspannung des LC-Oszillators und, gegebenenfalls, an internen Spannungsknoten direkt ein amplitudendemoduliertes Signal des Oszillators abgegriffen.

Die Änderungen in der Oszillationsfrequenz und/oder Oszillationsamplitude werden mit einer dem LC-Oszillator nachgeschalteten Demodulation erfasst. Die Demodulation erfolgt dabei entweder mit einem Frequenzdemodulator oder einem Amplitudendemodulator, wie es jeweils Ausführungsformen entspricht. Eine Kombination von einem Frequenzdemodulator mit einem Amplitudendemodulator entspricht einer weiteren Ausführungsform. Eine Umwandlung der Analogsignale in Digitalsignale erfolgt in Abhängigkeit der gewählten Wandler bzw. Demodulatoren vor oder nach der Wandlung bzw. Demodulation.

Die digitalen, gewandelten und/oder demodulierten Signale werden einer digitalen Datenverarbeitung zugeführt. Sie werden dort mit einem Mittel zur Bestimmung spektraler Komponenten der Magnetisierung der Probe auf Grundlage eines Modells transienter Induktivität und transienten Widerstands einer Spule, das auf der Datenverarbeitungsanlage bereitgestellt ist, weiter verarbeitet. Die spektralen Komponenten (ursprüngliche Spektrallinien einer Probe) dienen wiederum zur Ermittlung von Resonanzenergien (z.B. ausgedrückt über den Landé-Faktor (*g*-Faktor / *g*-Tensor) oder dem Verhältnis von Resonanzfrequenzen einer Probe und $B_0$).

Das Modell transienter Induktivität und transienten Widerstands einer Spule wird im Folgenden in vier Abschnitten eingeführt:

1. Komplexe Suszeptibilität/Permeabilität;
2. Stand der Technik für die Modellierung einer Nutzung eines LC-Oszillators zur Manipulation und Detektion einer Magnetisierung einer Probe unter Dauerstrich-Bedingungen;
3. Erfindungsgemäße Modellierung einer Nutzung eines LC-Oszillators zur Manipulation und Detektion einer Magnetisierung einer Probe unter transienten Bedingungen;
4. Verhältnis zwischen der Frequenz der Oszillation und der Amplitude eines LC-Oszillators und der Induktivität und dem effektiven Widerstand des eingesetzten induktiven Elements.

Zur Erläuterung sei bemerkt, dass zwischen der freien Oszillationsfrequenz des LC-Oszillators $\omega_{osc0}$, die vorliegt, wenn der Oszillator unbeeinflusst schwingt, und einer Oszillationsfrequenz, die durch die Magnetisierung einer Probe beeinflusst wird, $\omega_{osx,\chi}$ unterschieden wird. Zusätzlich wird auch der generelle Fall mit einer Oszillationsfrequenz $\omega_{osc}$ betrachtet.

## 1. Komplexe Suszeptibilität/Permeabilität

Das $B_1$-Feld und die magnetische Feldstärke $H_1$ innerhalb einer linearen Probe sind bei genügend (probenabhängig) niedrigen Frequenzen des $B_1$-Feldes proportional zueinander. Dies entspricht einer reellwertigen relativen Permeabilität $\mu_r$ und der Suszeptibilität $\chi_m$ der Probe, deren Zusammenhang $\mu_r = 1 + \chi_m$ ist. Bei höheren Frequenzen des $B_1$-Feldes kann es zu einer Zeitverschiebung zwischen dem $B_1$-Feld und der Feldstärke $H_1$ kommen. Diese Zeitverschiebung kann für den Sonderfall sinusförmiger Zeitverläufe als komplexe Permeabilität und Suszeptibilität der Probe abgebildet werden, gemäß

$$\underline{\mu_r} = \mu_r' - j \cdot \mu_r'' \text{ und } \underline{\chi_m} = \chi_m' - j \cdot \chi_m''.$$

Die komplexe Permeabilität und Suszeptibilität wird zum Beispiel in dem **Aufsatz 4** von N. Bloembergen und R.V. Pound (Radiation Damping in Magnetic Resonance Experiments, Physical Reviews, Vol 95 (1), 1954, S. 8-12) näher beschrieben.

## 2. Stand der Technik für die Modellierung einer Nutzung eines LC-Oszillators zur Manipulation und Detektion einer Magnetisierung einer Probe unter Dauerstrich-Bedingungen

In dem **Aufsatz 3** von T. Yalcin und G. Boero wird eine Methode offenbart, mittels derer LC-Oszillatoren für Dauerstrich ESR-Experimente verwendbar sind. Die Methode basiert auf der Grundlage, dass der Strom, der durch die Spule des LC-Oszillators fließt, ein kontinuierliches (Dauerstrich) Mikrowellen-Magnetfeld ($B_1$) erzeugt, dem eine Probe ausgesetzt ist. Dieses Feld ($B_1$) beeinflusst die Magnetisierung der Probe, was wiederum im LC-Oszillator als eine Änderung der Frequenz detektiert werden kann. Der Zusammenhang zwischen dem statischen Magnetfeld $B_0$, dem Mikrowellenfeld $B_1$ und der spinbasierten Magnetisierung der Probe $M_s$, als Summe der Magnetisierung eines Spinensembles $M_x$, ist eingeführt als

$M_x = (\chi' \cdot \cos(\omega_{osc0} \cdot t) + \chi'' \cdot \sin(\omega_{osc0} \cdot t)) \cdot 2H_1$, wobei $\omega_{osc0}$ die Frequenz der magnetischen Feldstärke $H_1$, die freie Oszillationsfrequenz, ist und $t$ die Zeit. Die freie Oszillationsfrequenz des Oszillators muss unter anregenden Bedingungen der Lamorfrequenz entsprechen bzw. nahe dieser sein. Dabei ist eine komplexe Magnetisierung der Probe (siehe oben), welche die Mikrowellen-Feldstärke $H_1$, gemäß $H_1 = B_1/\mu_0$, mit der stationären Magnetisierung eines Spinensembles $M_x$ unter Dauerstrichanregung verbindet, berücksichtigt,

## 3. Erfindungsgemäße Modellierung einer Nutzung eines LC-Oszillators zur Manipulation und Detektion einer Magnetisierung einer Probe unter transienten Bedingungen

Das Modell der Beziehung zwischen einem Spinensemble $M_x$, dem statischen Magnetfeld $B_0$ und dem Mikrowellenfeld $B_1$, die, wie oben aufgezeigt, zur Beschreibung von Dauerstrich ESR-Experimenten unter Nutzung von LC-Oszillatoren dient, ist nur für den stationären Zustand einer Magnetisierung anwendbar. Dies folgt daraus, dass dieses Modell auf einer Notation für einen Zeiger beruht oder, mathematisch ausgedrückt, auf einer Lösung einer Differentialgleichung unter Nutzung der Fouriertransformation, die nur für sinusförmige Anregungen unbegrenzter Zeitdauer die Einführung einer zeitlich unabhängigen, komplexen Suszeptibilität als Quotient aus dem Zeiger der Magnetisierung und der magnetischen Feldstärke $H_1$ zulässt.

Um diese Beschränkung aufzuheben und den Effekt, den ein zeitlich veränderliches Magnetfeld (transientes Magnetfeld $B_1(t, f)$) auf die Magnetisierung einer Probe hat, zu beschreiben, wird das neue Modell eingeführt, welches das unmittelbare $B_1$-Feld und die Probenmagnetisierung $M_s$ in Beziehung setzt zu einer probenabhängigen, zeitlich veränderlichen Induktivität und einem probenabhängigen, zeitlich veränderlichen Widerstand der Spule des LC-Oszillators. Naturgemäß umfasst dieser generelle Ansatz den Grenzfall der stationären Mikrowellenanregung.

Allgemein gilt, wenn eine magnetische Feldstärke $H$ durch einen Stromfluss in einer Spule erzeugt wird und eine Probe durchdringt, wird ein Magnetfeld $B$ in der Probe in Abhängigkeit von deren Materialeigenschaften erzeugt gemäß

$$\vec{B} = \mu_0 \cdot \vec{H} + \vec{M} = \mu_0 \cdot \left(\vec{H} + \chi_m \cdot \vec{H}\right) = \mu_0 \cdot (1 + \chi_m) \cdot \vec{H} = \mu_0 \cdot \mu_r \cdot \vec{H} \qquad (1.1)$$

wobei $\vec{M}$ die Magnetisierung in der Probe ist, $\chi_m$ deren magnetische Suszeptibilität und $\mu_r$ deren relative Permeabilität.

Weiterhin allgemein bekannt ist, dass die magnetische Feldstärke $H$ und das $B$-Feld mit einer Energiedichte pro Volumeneinheit $w_m$ verbunden werden können gemäß

$$w_m = \vec{B} \cdot \vec{H} = \vec{B} \cdot \left(\frac{1}{\mu_0} \cdot \vec{B} - \vec{M}\right) = \frac{1}{\mu_0} \cdot \vec{B} - \vec{B} \cdot \vec{M} \ . \qquad (1.2)$$

Wenn der Stromfluss, welcher die magnetische Feldstärke $H$ bewirkt, zeitlich veränderlich ist, kann die Änderungsrate der magnetischen Energie verknüpft werden mit einer Leistung gemäß

$$P = \frac{\partial W_m}{\partial t} = v(t) \cdot i(t) = \left[\frac{d[L(t) \cdot i(t)]}{dt} + R_{\text{sample}}(t) \cdot i(t)\right] \cdot i(t), \qquad (1.3)$$

wobei $W_m = \int w_m \mathrm{d}V$ die totale magnetische Energie, verknüpft mit der Induktionsspule ist, $v(t)$ der Spannungsabfall über der Spule, $i(t)$ der zugehörige Stromfluss, $L(t)$ die zeitlich veränderliche Induktivität, die verknüpfbar ist mit dem magnetischen Feld in der Spule. $R_{\text{sample}}(t)$ modelliert dabei einen möglichen, zeitlich veränderlichen Verlust, welcher durch die Magnetisierung der Probe verursacht wird.

Durch Kombination von (1.2) mit (1.3) erhält man:

$$P = \int_V \left[\frac{1}{\mu_0} \cdot \frac{\mathrm{d}}{\mathrm{d}t}[B(t)]^2 - \frac{\mathrm{d}}{\mathrm{d}t}\left[\vec{B}(t) \cdot \vec{M}(t, \vec{r})\right]\right] \mathrm{d}V$$

$$= \left[\frac{\mathrm{d}}{\mathrm{d}t}L(t) \cdot i(t) + L(t) \cdot \frac{\mathrm{d}}{\mathrm{d}t}i(t) + R_{\text{sample}}(t) \cdot i(t)\right] \cdot i(t) \qquad (1.4)$$

mit $\vec{r}$ = Abstandsvektor vom Ursprung für die Integration über das Volumen.

Unter der Annahme, dass das $B_1$-Feld (in der Probe) durch einen Stromfluss in der Spule induziert wird gemäß $\vec{B}_1 = \vec{B}_u \cdot i(t)$, wobei $\vec{B}_u$ das sogenannte unitäre Magnetfeld ist, wird die Gleichung (1.4) umgeschrieben zu:

$$\int_V [\frac{1}{\mu_0} \cdot \vec{B}_u^2(\vec{r}) \cdot \frac{\mathrm{d}}{\mathrm{d}t}[i(t)]^2 - \vec{B}_u(\vec{r}) \cdot \frac{\mathrm{d}}{\mathrm{d}t}[i(t) \cdot \vec{M}(t, \vec{r})]] \, \mathrm{d}V$$

$$= \frac{1}{\mu_0} \cdot \int_V \left[ \vec{B}_u^2(\vec{r}) \cdot \frac{\mathrm{d}}{\mathrm{d}t}[i(t)]^2 \right] \mathrm{d}V$$

$$- \int_{V_s} [\vec{B}_u(\vec{r}) \cdot \frac{\mathrm{d}}{\mathrm{d}t}[i(t)] \cdot \vec{M}(t, \vec{r}) + \vec{B}_u(r) \cdot i(t) \cdot \frac{\mathrm{d}}{\mathrm{d}t}[\vec{M}(t, \vec{r})]] \mathrm{d}V$$

$$= \left[ \frac{\mathrm{d}}{\mathrm{d}t}L(t) \cdot i(t) + L(t) \cdot \frac{\mathrm{d}}{\mathrm{d}t}i(t) + R_{\mathrm{sample}}(t) \cdot i(t) \right] \cdot i(t)$$

$$= \left[ \frac{\mathrm{d}}{\mathrm{d}t}L(t) + R_{\mathrm{sample}}(t) \right] \cdot i^2(t) + L(t) \cdot i(t) \cdot \frac{\mathrm{d}}{\mathrm{d}t}i(t)$$

$$= \left[ \frac{\mathrm{d}}{\mathrm{d}t}L(t) + R_{\mathrm{sample}}(t) \right] \cdot i^2(t) + \frac{1}{2} \cdot L(t) \cdot \frac{\mathrm{d}}{\mathrm{d}t}[i(t)]^2 \qquad (1.5)$$

mit $V_s$ = Probenvolumen.

Durch Vergleich der Ausdrücke auf der linken und rechten Seite der Gleichung und durch Ersetzen der Induktivität $L(t)$ durch eine Kombination eines von der Probe unabhängigen Ausdrucks $L_0$ der Induktivität der Spule und eines von der Probe abhängigen Ausdrucks $\Delta L_{\mathrm{sample}}$ für die detektierbare Induktivität der Probe im transienten Magnetfeld gemäß

$L(t) = L_0(t) + \Delta L_{\mathrm{sample}}(t)$ werden die folgenden Ausdrücke für $L_0, \Delta L_{\mathrm{sample}}$ und $R_{\mathrm{sample}}$ gefunden:

$$L_0 \equiv 2 \cdot \int_V [\frac{1}{\mu_0} \cdot \vec{B}_u^2(\vec{r})] \mathrm{d}V$$

$$\Delta L_{\mathrm{sample}}(t) \equiv \int_{V_s} \left[ -\vec{B}_u(\vec{r}) \cdot \frac{\vec{M}(t, \vec{r})}{i(t)} \right] \mathrm{d}V$$

$$\frac{d}{dt}\Delta L_{\mathrm{sample}}(t) + R_{\mathrm{sample}}(t) = \int_{V_s} [-\vec{B}_u(\vec{r}) \cdot \frac{\frac{\mathrm{d}}{\mathrm{d}t}[\vec{M}(t, \vec{r})]}{i(t)}] \mathrm{d}V$$

$$\leftrightarrow R_{\mathrm{sample}}(t) \equiv \int_{V_s} \left[ -\vec{B}_u(\vec{r}) \cdot \frac{\frac{\mathrm{d}}{\mathrm{d}t}[\vec{M}(t, \vec{r})]}{i(t)} \right] \mathrm{d}V - \frac{\mathrm{d}}{\mathrm{d}t}\Delta L_{\mathrm{sample}}(t). \qquad (1.6)$$

Die Größe $L_0$ kann direkt über die Geometrie der Spule ermittelt werden.

Aus der Gleichung (1.6) folgt, dass die Gegenwart einer zeitlich veränderlichen Magnetisierung zu einer Änderung der Induktivität in der Probe führt, welche proportional ist zum Integral besagter Magnetisierung über die gesamte Probe, welches normiert ist auf den Stromfluss in der Induktionsspule gemäß

$$\Delta L_{\mathrm{sample}}(t) \equiv \int_{V_s} \left[ -\vec{B}_u(\vec{r}) \cdot \frac{\vec{M}(t, \vec{r})}{i(t)} \right] \mathrm{d}V = \int_{V_s} [-\vec{B}_1(\vec{r}) \cdot \frac{\vec{M}(t, \vec{r})}{i^2(t)}] \mathrm{d}V, \qquad (1.7)$$

und als Term in einer Ausführungsform vom Mittel zur Bestimmung spektraler Komponenten der Magnetisierung der Probe auf Grundlage des physikalischen Modells transienter Induktivität und transienten Widerstands einer Spule umfasst wird.

Die Gleichung (1.7) wird überprüft auf eine Konsistenz mit dem im **Aufsatz 3** gefundenen Ergebnissen für den Dauerstrichfall. Für den Grenzfall einer kontinuierlichen (Dauerstrich) Anregung, sind $\vec{B}_1$ und $i(t)$ gegeben durch

$$\vec{B}_1 = \widehat{\vec{B}_1} \cdot \cos(\omega_{osc,\chi} \cdot t)$$ und $i(t) = \hat{i} \cdot cos(\omega_{osc,\chi} \cdot t)$ ( $\widehat{\vec{B}_1}$ und $\hat{i}$ sind die Amplituden der genannten Größen).

Daraus folgt, dass $$i^2(t) = \frac{\hat{i}}{2} \cdot (1 + \cos(2\omega_{osc,\chi} \cdot t)) \; .$$ Im Dauerstrichfall wird nur das stationäre Signal detektiert, wodurch der zeitlich veränderliche Anteil von $i^2(t)$ herausge-mittelt wird und die detektierbare Induktivität der Probe im Dauerstrichexperiment gegeben ist mit

$$\Delta L_{\text{sample,CW}}(t) = \text{Re}\left\{\int_{V_s}[-\vec{B}_u(\vec{r}) \cdot \vec{M}(t,\vec{r})]\mathrm{d}V\right\} = -\int_{V_s}\vec{B}_u(\vec{r}) \cdot \frac{\chi' \cdot \vec{B}_u(\vec{r})}{\mu_0}\mathrm{d}V$$

$$= -\frac{1}{\mu_0}\int_{V_s}\chi'\left(\vec{B}_u(\vec{r})\right)^2\mathrm{d}V \tag{1.8a}$$

Für einen über das gesamte Volumen der Probe konstanten Wert ihrer Suszeptibilität $\chi'$ lässt sich dieser Ausdruck weitervereinfachen zu

$$\Delta L_{\text{sample,CW}} = -\chi'(\int_{V_s}\left(\vec{B}_u(\vec{r})\right)^2\mathrm{d}V = -\chi'\int_{V_s}\left(\vec{B}_u(\vec{r})\right)^2\mathrm{d}V \cdot \frac{\int_V\left(\vec{B}_u(\vec{r})\right)^2\mathrm{d}V}{\int_V\left(\vec{B}_u(\vec{r})\right)^2\mathrm{d}V}$$

$$= -\chi' \cdot \frac{\left(\int_{V_s}\left(\vec{B}_u(\vec{r})\right)^2\mathrm{d}V\right)}{\int_V\left(\vec{B}_u(\vec{r})\right)^2\mathrm{d}V} \cdot \int_V\left(\vec{B}_u(\vec{r})\right)^2\mathrm{d}V$$

$$= -\chi' \cdot \eta \cdot L_0 , \tag{1.8b}$$

wobei $\eta$ der sogenannte Füllfaktor (entspricht dem Verhältnis von Probenvolumen zu Gesamtvolumen der Spule) ist. Dies entspricht genau dem Ergebnis aus dem **Aufsatz 3.**
Darüber hinaus, wird der effektive Spulenwiderstand, der unter der Beeinflussung der Spule durch die Probe anliegt, modifiziert zu

$$R_{\text{sample,tot}}(t) = \frac{d}{dt}\Delta L_{\text{sample}}(t) + R_{\text{sample}}(t) = \int_{V_s}\left[-\vec{B}_1(\vec{r}) \cdot \frac{\frac{d}{dt}[\vec{M}(t,\vec{r})]}{i^2(t)}\right]\mathrm{d}V. \tag{1.9}$$

Daraus folgt, dass, im Gegensatz zur Induktivität der Spule, die Änderung im Widerstand der Spule proportional ist zum Integral der zeitlichen Ableitung der Probenmagnetisierung über das Probenvolumen, normiert auf den Spulenstrom.

Zu beachten ist, dass aus der Modulation von $\vec{B}_1$ mit $\vec{M}$ und $\frac{\mathrm{d}}{\mathrm{d}t}\vec{M}$ in Gleichung (1.7) und (1.9) direkt folgt, dass sowohl die auf die Probe bezogene Änderung der Induktivität als auch die auf die Probe bezogenen Änderung des Widerstandes der Spule spektrale Komponenten bei Frequenzen $\omega_{\text{osc0}} \pm \omega_i$ enthalten, Dabei wurde von der Annahme spektraler Komponenten der Probenmagnetisierung bei $\omega_i$ und stückweise (d.h. zeitlich begrenzten) sinusförmigen Stromflüssen in der Spule ($i(t) = \hat{\imath} \cdot \cos(\omega_{\text{osc0}} \cdot t)$, für $t \in [t_1, t_2]$, mit $\omega_{\text{osc0}}$ = Frequenz des Spulenstroms (bzw. des Oszillators) und $t_1$, $t_2$ beliebige Anfangs- und Endzeitpunkte ausgegangen. Spektrale Komponenten, die zum DC Anteil

in $i^2(t) = \frac{\hat{\imath}}{2} \cdot (1 + \cos(2\omega_{\text{osc0}} \cdot t))$ gehören, sind die zu nutzenden Frequenzen, und hochfrequente Komponenten, die aus dem fluktuierenden Anteil in $i^2(t) = \frac{\hat{\imath}}{2} \cdot (1 + \cos(2\omega_{\text{osc0}} \cdot t))$ resultieren, sind unerwünscht.

## 4. Verhältnis zwischen der Frequenz der Oszillation und der Amplitude eines LC-Oszillators und der Induktivität und dem effektiven Widerstand des eingesetzten induktiven Elements

Im Folgenden wird aufgezeigt, wie die Änderungen in der Induktivität und dem effektiven Widerstand einer Spule mit einer Änderung der Frequenz und Amplitude einer Oszillation der Spule zusammenhängt, wenn diese Teil eines LC-Oszillators ist.
Unter der Vernachlässigung von Effekten höherer Ordnung kann die Frequenz eines Oszillators als eine Funktion der Induktivität des Schwingkreises $L$, seiner Kapazität $C$ und dem äquivalenten Leitwert des Schwingkreises

$$G_t \approx \frac{R_{\text{eff}}}{\omega_{\text{LC}}^2 \cdot L_0^2},$$ mit $R_{\text{eff}}$ = effektiver Widerstand der Spule (allgemeiner Fall) und

$$\omega_{LC} = \frac{1}{\sqrt{L_0 \cdot C}} = \text{Resonanzfrequenz}$$

des Schwingkreises, beschrieben werden gemäß

$$\omega_{\text{osc},\chi} = \frac{1}{\sqrt{L_{\text{eff}} \cdot C}} \cdot [1 - f(L_{\text{eff}}, C, G_t, G_m)] \approx \frac{1}{\sqrt{L_{\text{eff}} \cdot C}}, \tag{1.10}$$

mit $G_m$ der Steilheit (Transkonduktanz) des aktiven Transistors, der den negativen Widerstand bewirkt, welcher als Stabilisierung der Oszillation dient. Ferner ist Gleichung (1.10) vereinfacht durch die Tatsache, dass $f(L,C,G_t,G_m) \ll 1$ für jeden praktisch nutzbaren LC-Oszillator ist. Schreibt man außerdem die effektive Induktivität der Spule als einen von der Probe abhängigen und unabhängigen Teil (siehe auch oben)

$L_{\text{eff}} = L_0 + \Delta L_{\text{sample}}$, und nimmt ferner an, wie es für die meisten praktischen Anwendungen gültig ist, dass $\Delta L_{\text{sample}} \ll L_0$, wird eine Näherungsfunktion für die Frequenz eines LC-Oszillators, der eine Probe mit einer zeitlich veränderlichen Magnetisierung in der erregbaren Region seiner Spule aufweist, aufgestellt gemäß

$$\omega_{\text{osc},\chi} \approx \frac{1}{\sqrt{L_{\text{eff}} \cdot C}} = \frac{1}{\sqrt{[L_0 + \Delta L_{\text{sample}}] \cdot C}} \approx \frac{1}{\sqrt{L_0 \cdot C}} - \frac{1}{2} \cdot \frac{1}{(L_0 \cdot C)^{\frac{3}{2}}} \cdot C \cdot \Delta L_{\text{sample}}. \tag{1.11a}$$

Die Näherungsfunktion wird nach dem 2. Glied abgebrochen und unter dem vernachlässigbaren Anteil höherer Glieder wird

$$\omega_{\text{osc},\chi} = \frac{1}{\sqrt{L_0 \cdot C}} - \frac{1}{2} \cdot \frac{1}{(L_0 \cdot C)^{\frac{3}{2}}} \cdot C \cdot \Delta L_{\text{sample}} \tag{1.11b}$$

als Term zur Modellierung der spektralen Komponenten einer Probe gesetzt., welcher in einer Ausführungsform vom Mittel zur Bestimmung spektraler Komponenten der Magnetisierung der Probe auf Grundlage des physikalischen Modells transienter Induktivität und transienten Widerstands einer Spule umfasst wird.

Da die auf die Probe bezogene Induktivität $\Delta L_{\text{sample}}$ gemäß Gleichung (1.9) proportional ist zum Integral der Magnetisierung der Probe normiert auf den Stromfluss in der Spule, inkorporiert die Frequenz der Oszillation folgerichtig die in Gleichung (1.9) gegebene Proportionalität. Eine zeitlich veränderliche Magnetisierung einer Probe kann somit durch Erfassen des instantanen Wertes der Oszillationsfrequenz des LC-Oszillators ($\omega_{\text{osc},\chi}$) ermittelt werden. Zusätzlich bewirken die zur Probe gehörigen spektralen Komponenten der Induktivität bei $\omega_{\text{osc}0} \pm \omega_i$, die durch die Änderung der Induktivität des Proben bezogenen Anteils $\Delta L_{\text{sample}}$ hervorgerufen werden, eine Modulation der Frequenz des Oszillators mit der Modulationsfrequenz $\omega_{\text{osc}0} \pm \omega_i$ und erzeugen somit spektrale Komponenten in der Spannung des Oszillators bei $\omega_{\text{osc}0} \pm (\omega_{\text{osc}0} \pm \omega_i)$. Diese Komponenten sind durch gängige Demodulation der Frequenzen (FM, Frequenzmodulation) ermittelbar und ermöglichen damit die Bestimmung der Induktivität der Probe $\Delta L_{\text{sample}}$. Daraus wird dann deren Magnetisierung bzw. die zugehörigen spektralen Komponenten und das resonante Verhalten bestimmt.

Die Oszillationsamplitude eines LC-Oszillators hängt im Allgemeinen sowohl von der effektiven Induktivität $L_{eff}$ als auch vom effektiven Widerstand $R_{eff}$ der verwendeten Spule ab, wobei die Abhängigkeit vom Widerstand deutlich stärker ist. Generell lässt sich die Oszillationsamplitude $A_{osc}$ somit schreiben als

$$A_{osc} = f(R_{eff}, L_{eff}, C, G_m). \tag{1.12a}$$

Da die spininduzierten Änderungen des Spulenwiderstands im Allgemeinen klein sind gegenüber dem ohmschen Spulenwiderstand $R_0$, lässt sich Gleichung 1.12a unter Verwendung einer Taylorreihe, die nach dem 2. Term abgebrochen wird, unter dem Vernachlässigen höherer Glieder umschreiben als

$$A_{osc} = A_{osc} \Big|_{R_{eff}=R_0} + \frac{\partial A_{osc}}{\partial R_{eff}} \Big|_{R_{eff}=R_0} \cdot R_{sample,tot} \tag{1.12b}$$

Gleichung 1.12b wird als Term zur Modellierung der spektralen Komponenten einer Probe gesetzt, welcher in einer anderen Ausführungsform vom Mittel zur Bestimmung spektraler Komponenten der Magnetisierung der Probe auf Grundlage des physikalischen Modells transienter Induktivität und transienten Widerstands einer Spule umfasst wird. Diese Gleichung ist vom verwendeten Oszillator abhängig und muss für den konkret angewandten Fall angepasst werden.

Im Falle eines LC-VCO konkretisiert sich die Gleichung 1.12b zu

$$A_{osc} = 8 \cdot \sqrt{\frac{2}{3}} \cdot \frac{n \cdot I_{\text{BIAS}}}{G_{\text{m}}} \cdot \sqrt{1 - \frac{2 \cdot R_0}{\omega_{LC}^2 \cdot L_0^2}} + \left. \frac{\partial A_{\text{osc}}}{\partial R_{\text{eff}}} \right|_{R_{\text{eff}} = R_0} \cdot R_{\text{sample,tot}}$$

mit $n$ = Emissionsfaktor im Unterschwellenbereich und $I_{BIAS}$ = DC-Ruhestrom des Oszillators (Biasstrom).

Die Aufstellung der Funktion 1.12b erfolgt auf der Grundlage, dass unter den meisten experimentellen Bedingungen der ohmsche Spulenwiderstand $R_0$ signifikant größer ist als die durch die Probe induzierte Änderung im Spulenwiderstand $R_{\text{sample,tot}}$. Im Gegensatz zur durch die Probe induzierten Änderung der Induktivität $\Delta L_{\text{sample}}$ führt die durch die Probe induzierte Änderung im Widerstand $R_{\text{sample,tot}}$ hauptsächlich zu einer Modulationen der Amplitude der Oszillationsfrequenz der Spule (d.h. des Oszillators). Die Modulationen der Amplitude bewirken spektrale Anteile in der Oszillatorausgangsspannung bei $\omega_{\text{osc0}} \pm (\omega_{\text{osc0}} \pm \omega_i)$, die wiederum mit gängiger Demodulation der Amplitude (AM, Amplitudendemodulation) ermittelt werden können und somit auch die Magnetisierung bzw. die zugehörigen spektralen Komponenten und resonantes Verhalten.

Dementsprechend können nach konventioneller FM- bzw. AM-Demodulation die spektralen Komponenten der Magnetisierung bei Frequenzen von $\omega_{osc0} \pm \omega_i$ detektiert werden und, da die Oszillationsfrequenz $\omega_{osc0}$ bekannt ist, somit eindeutig und quantitativ spektralen Komponenten bei den Frequenzen $\omega_i$ zugeordnet werden.

FM- und AM-Demodulation können dabei unterschiedlich komplex in der Durchführung sein, so dass sich hier Unterschiede in der Detektorhardware ergeben. Zum Beispiel gibt es beim LC-Tank Oszillator einen Knoten mit der intrinsischen AM-Demodulation, an der diese abgegriffen werden kann. Grundlagen zur Amplitudendetektion in einem CMOS-LC-Oszillator sind in dem **Aufsatz 5** von P. Kinget (Amplitude detection inside CMOS LC oscillators, 2006 IEEE International Symposium on Circuits and Systems, Vol. 1-11, Proceedings 2006, S. 5147-5150) gegeben. Für die FM-Demodulation kommen z.B. Phasenregelschleifen (analog oder digital) oder sogenannte Teager-Energie-Operatoren zum Einsatz.

Eine Erfassung beider Spektren, wie es einer Ausführungsform entspricht, birgt den Vorteil, dass eine intrinsische "Baseline Calibration" vorgenommen werden kann, d.h. spektrale Komponenten, die in beiden Spektren auftauchen sind als echt aufzufassen, bei allen anderen handelt es sich hingegen um sogenannte Messartefakte.

Die ermittelten spektralen Komponenten dienen - wie bereits erwähnt - zur Bestimmung von Resonanzenergien, z.B. ausgedrückt über den Landé-Faktor ($g$-Faktor / $g$-Tensor) oder dem Verhältnis von Resonanzfrequenzen einer Probe und dem Magnetfeld $B_0$ oder ihres transient Verhaltens (z.B. Relaxation). Diese werden von der Datenverarbeitungsanlage mit dazu geeigneten Mitteln ausgegeben, um sie z.B. einem Einsatz in einer Prozessführung oder einer Qualitätskontrolle zuzuführen sowie zur bildgebenden Magnetresonanztomographie zu nutzen.

Das neue Modell zur Verarbeitung der Signale aus der erfindungsgemäßen Vorrichtung, das zur Ermittlung der spektralen Komponenten einer Probe dient, ermöglicht es erstmals das Verhalten einer Spule in Hinblick auf die Auswirkungen einer transienten Magnetisierung einer Probe hin so zu analysieren, dass die zur Probencharakterisierung nötigen spektralen Komponenten bereitgestellt werden können. Dies wiederum ermöglicht erstmals die Reduktion und Miniaturisierung des Aufbaus eines gepulsten ESR-oder NMR-Experiments gemäß der hier vorgestellten erfindungsgemäßen Lösung mit einem LC-Oszillator als Sende- und Empfangsstation.

Die Erfindung stellt damit zudem vorteilhaft eine Vorrichtung zur Erzeugung und Detektion einer transienten Magnetisierung einer Probe zur Verfügung, die keinen Resonator benötigt. Damit ist eine Detektion der Magnetisierung der Probe während der Anregung bzw. während des Anliegens des transienten Magnetfelds möglich. Hiermit erschließen sich ESR- und NMR-Experimente mit einer bisher nicht verwirklichten zeitlichen Auflösung einer Messung der transienten Magnetisierung der Probe.

Ein weiterer Vorteil der Verwendung von LC-Oszillatoren in der erfindungsgemäßen Lösung für transiente Experimente ist, dass im Vergleich zur resonatorbasierten Detektion kein "Duplexer" oder "Zirkulator" zur Entkopplung von Sende- und Empfangsvorrichtung benötigt wird und somit eine weitere Reduktion an Bauteilen und Vereinfachung der Vorrichtung erfolgt.

Die Vorrichtung ist bei Bedarf miniaturisierbar, da alle erforderlichen Komponenten in integrierter Schaltungstechnik ausführbar sind.

Zusätzlich wird die Wechselstromleistung der Oszillatoren direkt in das gewünschte $B_1$-Feld durch den hochfrequenten (RF/Mikrowelle) Strom, der durch die Spule läuft, umgesetzt, ohne durch eine 50 $\Omega$ - Schaltungsumgebung zu laufen. Hierdurch muss insgesamt weniger Leistung bei der Larmorfrequenz erzeugt werden und es kann somit elektrische Energie eingespart werden.

In einer Ausführungsform werden die erste und zweite zeitabhängige Wellenform mit einer Datenverarbeitungsanlage (zum Beispiel ein Personalcomputer) generiert, wobei Digital-Analog-Umsetzer dem LC-Oszillator vorgeschaltet sind.

In einer weiteren Ausführungsform ist der Digital-Analog-Umsetzer für die zweite zeitabhängige Wellenform in der Stromquelle des LC-Oszillators integriert. Dies verursacht weniger parasitäre Kapazität in den Zuleitungen, so dass höhere Zeitauflösungen bei der Modulation der Einhüllenden des $B_1$-Feldes erzielt werden können. Dieser Umstand ist wichtig für die aus der Optimalsteuerungstheorie abgeleiteten sogenannten "Optimalsteuerungs-pulse". Mit der Optimalsteuerungstheorie kann mathematisch berechnet werden, welche Einhüllende und Phase das $B_1$ Feld haben sollte, um die Spinmagnetisierung möglichst effizient zu manipulieren.

Die Ausführung des LC-Oszillators ist in einer dritten Ausführungsform durch einen LC-VCO (Voltage Controlled Oscillator, Spannungsgesteuerter Oszillator) realisiert. Die Verwendung von LC-VCOs ermöglicht ein unabhängiges Einstellen von Frequenz und Amplitude des Oszillators und somit auch von Frequenz und Amplitude des $B_1$-Feldes, was für eine Optimierung der experimentellen Bedingungen vorteilhaft ist.

Die Schaltungsanordnung des LC-VCO ist bevorzugt, wie es einer Ausführungsform entspricht, wie folgt ausgeführt. Eine differentielle Kapazitätsdiode (Varaktor) und eine differentielle Induktivität dienen zur Bildung des LC-Schwingkreises. Zwei kreuzgekoppelte Transistoren gewährleisten eine stabile Oszillation im differentiellen Output (d.h. der Ausgangsspannung) durch negativen Widerstand und Nichtlinearität zwischen zwei Knotenpunkten. Die Abstimmungseigenschaften werden durch die differentielle Kapazitätsdiode gewährleistet. Die zeitabhängige Variation der Oszillationsamplitude wird z.B. umgesetzt durch eine Manipulation der Spannungsversorgung des LC-VCO. Diese einfache Ausführung eines LC-VCO gewährleistet eine geringe Leistungsaufnahme, geringen Platzbedarf und arbeitet zudem auch bei niedrigen (bis zu kryogenen) Temperaturen.

Der LC-VCO ist in einer weiteren Ausführungsform erweitert durch eine spannungsgesteuerte Stromquelle, die in einer nächsten Ausführungsform als digitale Stromsteuereinrichtung realisiert ist. Die zusätzliche Stromquelle ermöglicht die Anpassung der Amplitude des $B$-Feldes. Die Aufteilung in einen nicht veränderlichen und veränderlichen Anteil der Stromquelle macht den Entwurf des veränderlichen Anteils einfacher, da für eine gewünschte Auflösung in der Steuerung der Stromzufuhr eine geringere Auflösung in der digitalen Bitbreite (der Steuerung der Stromquelle) benötigt wird.

Ein Abwärtsmischer mit Quadraturpfaden zur Verarbeitung der Ausgangsspannung des LC-Oszillators, der diesem nachgeschaltet ist, entspricht ebenfalls einer Ausführungsform des LC-Oszillators. Quadraturdetektion verhindert den Verlust von Informationen über sich zeitlich schnell ändernde Magnetisierungskomponenten (gebunden an kurze Relaxationszeiten). Die Quadraturmischung ermöglicht dabei eine Frequenz des LC-Oszillators, die von der Resonanzfrequenz genügend weit entfernt liegt, ohne die Probe anzuregen. Dabei muss Resonanzfrequenz der Probe nur wenig oberhalb der Frequenz des LC-Oszillators liegen bzw. kann sogar unterhalb dieser liegen. Dies wiederum spart Leistung und ermöglicht den Entwurf von Vorrichtungen zur Erzeugung und Detektion einer transienten Magnetisierung einer Probe, die mit sehr hohen $B_0$-Feldern, > 2 T, betrieben werden kann. Mischer, die z.B. auf einer monolithischen Integration zusammen mit dem LC-Oszillator untergebracht sind, ermöglichen ein Abwärtsmischen mit geringer Leistungsaufnahme, da z.B. keine hochfrequenten 50 $\Omega$-Puffer benötigt werden.

Ein Phasenregelkreis mit zwei Referenzoszillatoren ist in einer Ausführungsform in den LC-VCO schaltungstechnisch eingebunden. Dies garantiert, dass bei einer Folge von Anregungspulsen (transiente Magnetfelder) in einem ESR- oder NMR-Experiment die Phaseninformation aufeinanderfolgender Pulse nicht beim Schalten des LC-VCO zwischen einer Resonanzfrequenz und einer von dieser entfernten Frequenz verloren geht.

Die aufgeführten Ausführungsformen sind unbeschränkt unter Berücksichtigung schaltungstechnischer Gesichtspunkte kombinierbar.

Die Vorrichtung kann auch ausgeführt werden, indem der LC-Oszillator nur in seiner Funktion als Sendestation zur Erzeugung eines $B_1$-Feld genutzt wird, wobei die Detektion der Magnetisierung der Probe mit zusätzlichen Mitteln erfolgt. Diese zusätzlichen Mittel können weitere Oszillatoren oder Resonatoren (induktiv) sein. Die Detektion kann aber auch mechanisch, elektrisch oder optisch erfolgen.

Das erfindungsgemäße Verfahren zur Erzeugung und Detektion einer transienten Magnetisierung einer Probe weist gemäß Anspruch 13 mindestens die im Folgenden aufgeführten Schritte auf.

Zur Durchführung des Verfahrens genügt dabei eine erfindungsgemäße Vorrichtung, gemäß den Ansprüchen 1 bis 10, wie sie oben beschrieben ist.

Eine Probe, deren magnetische Eigenschaften bestimmt werden sollen, wird an einem Probenort angeordnet. Der Probenort ist ein Ort in einer Vorrichtung zur Erzeugung und Detektion einer transienten Magnetisierung einer Probe, an dem sowohl das statische oder dynamische (Gradienten-) Magnetfeld ($B_0$) als auch, gegebenenfalls, das transiente Magnetfeld ($B_1$) anliegen.

Ein statisches oder dynamisches Magnetfeld vorbestimmter Richtung und Stärke wird am Probenort bereitgestellt. Das Magnetfeld entspricht dem Magnetfeld $B_0$, das zur Magnetisierung einer Probe dient. Das Magnetfeld kann dabei von beliebiger Stärke sein, solange die Frequenz eines anregenden $B_1$-Magnetfelds entsprechend den Reso-

nanzbedingungen gewählt wird.

Ein transientes Magnetfeld, das dem anregenden Magnetfeld $B_1$ entspricht, wird mit einem LC-Oszillator, dessen Oszillationsfrequenz vom Wert eines induktiven Elements des LC-Oszillators abhängt, erzeugt. Die Anordnung des LC-Oszillators ist dabei erfindungsgemäß so gewählt, dass sich die Probe bzw. der Probenort im Nahfeld des LC-Oszillators befindet.

Transiente Magnetfelder sind dabei Magnetfelder, die durch eine Änderung der Frequenz im LC-Oszillator erzeugt werden, die von beschränkter Zeitdauer ist. Die Form der Änderung ist dabei nicht beschränkt und kann z.B. stufenförmig, sägezahnförmig oder als Spitze anfallen.

Die Dauer, Anzahl und Form der transienten Magnetfelder wird entsprechend den Anforderungen der Probe und der gewünschten Manipulation des Spinensembles in der Probe gewählt.

Im einfachsten Fall ist die Pulslänge probenabhängig so zu wählen, dass die Magnetisierung in der Probe um $\theta = 90°$ gekippt wird ($\theta = \gamma \cdot B_1 \cdot \tau_{puls}$, $\tau_{puls}$ = Zeitdauer des Anlegens des resonanten $B_1$-Feldes, $\gamma$ = gyromagnetisches Verhältnis), da so die transversale Magnetisierung maximiert wird, welche auch durch den erfindungsgemäßen LC-Oszillator detektiert wird.

Die Stärke des $B_1$-Feldes ist dabei groß genug, um 90°-Pulslängen ($\theta = 90°$) mit $\tau_{puls}$ im Sub-Nanosekunden Bereich zu erzeugen, so dass hierdurch in Kombination mit der Möglichkeit zur Detektion während der Anregung auch sogenannte Rabi-Oszillationen für Proben mit kurzen $T_2$-Relaxationszeiten direkt gemessen werden können. Die Stärke des $B_1$-Feldes wird dabei durch geeignete Wahl der Oszillatorversorgungsspannung bzw. des Oszillatorruhestroms sowie durch geeignete Wahl der Spuleninduktivität im Verhältnis zur frequenzbestimmenden Kapazität eingestellt.

Das transiente Magnetfeld, das so vom LC-Oszillator generiert wird, genügt in Frequenz und Einhüllender mindestens dazu, eine Magnetisierung einer Probe im $B_0$-Feld aus ihrer Gleichgewichtslage auszulenken.

Die transiente Magnetisierung der Probe wird als transiente Induktivität und transienter Widerstand der Spule des LC-Oszillators durch Abgreifen einer Ausgangspannung des LC-Oszillators vor, während und in der Folge des transienten Magnetfeldes erfasst. Die Änderung der Magnetisierung der Probe bewirkt eine Änderung im induktiven Element des LC-Oszillators, die sich als Änderung der Oszillationsfrequenz und/oder Oszillationsamplitude des LC-Oszillators in einer Ausgangspannung desselben detektieren lässt. Dazu wird die Ausgangspannung des LC-Oszillators und, gegebenenfalls, an internen Spannungsknoten direkt ein amplitudendemoduliertes Signal des Oszillators abgegriffen.

Die Änderungen in der Oszillationsfrequenz und/oder Oszillationsamplitude werden mit dem LC-Oszillator nachgeschalteten Frequenz- und Amplituden-Demodulatoren erfasst. Eine Umwandlung der Analogsignale in Digitalsignale erfolgt in Abhängigkeit der gewählten Wandler bzw. Demodulatoren vor oder nach der Wandlung bzw. Demodulation.

Die digitalen, demodulierten Signale werden einer digitalen Datenverarbeitung zugeführt. Sie werden dort in einem hinterlegten Modell transienter Induktivität und transienten Widerstands einer Spule zur Ermittlung der ursprünglichen Spektrallinien einer Probe bearbeitet.

Das Modell entspricht dem oben bereits für die erfindungsgemäße Vorrichtung eingeführten Modell gemäß der dort aufgeführten Abschnitte:

1. Komplexe Suszeptibilität/Permeabilität;
3. Erfindungsgemäße Modellierung einer Nutzung eines LC-Oszillators zur Manipulation und Detektion einer Magnetisierung einer Probe unter transienten Bedingungen;
4. Verhältnis zwischen der Frequenz der Oszillation und der Amplitude eines LC-Oszillators und der Induktivität und dem effektiven Widerstand des eingesetzten induktiven Elements.

Dem neuen Modell entsprechend können nach der konventionellen FM- bzw. AM-Demodulation die spektralen Komponenten der Magnetisierung bei Frequenzen von $\omega_{RF} \pm \omega_i$ detektiert werden und, da die Oszillationsfrequenz bekannt ist, somit eindeutig und quantitativ spektralen Komponenten bei den Frequenzen $\omega_i$ zugeordnet werden. Eine Erfassung beider Spektren birgt den Vorteil, dass eine intrinsische "Baseline Calibration" vorgenommen werden kann, d.h. spektrale Komponenten, die in beiden Spektren vorhanden sind, sind als echt aufzufassen. Bei allen anderen handelt es sich hingegen um sogenannte Messartefakte.

Die ermittelten spektralen Komponenten dienen zur Bestimmung von Resonanzenergien, z.B. ausgedrückt über den Landé-Faktor ($g$-Faktor / $g$-Tensor) oder das Verhältnis von Resonanzfrequenzen einer Probe und des Magnetsfelds $B_0$ oder deren transienten Verhaltens (z.B. Relaxation), welche von der Datenverarbeitungsanlage ausgegeben werden, um sie z.B. einem Einsatz in einer Prozessführung oder einer Qualitätskontrolle zuzuführen sowie zur bildgebenden Magnetresonanztomographie zu nutzen.

Das neue Modell zur Verarbeitung der Signale aus dem erfindungsgemäßen Verfahren zur Ermittlung der spektralen Komponenten einer Probe ermöglicht es erstmals, das Verhalten einer Spule in Hinblick auf die Auswirkungen einer transienten Magnetisierung einer Probe so zu analysieren, dass die zur Probencharakterisierung nötigen spektralen Komponenten bereitgestellt werden können.

Das erfindungsgemäße Verfahren stellt damit zudem vorteilhaft ein Verfahren zur Erzeugung und Detektion einer transienten Magnetisierung einer Probe zur Verfügung, bei dem Signale zur Detektion der Magnetisierung einer Probe während der Anregung bzw. während des Anliegens eines transienten Magnetfelds erfasst werden können. Damit sind ESR- und NMR-Experimente mit einer bisher nicht realisierten zeitlichen Auflösung der Messung transienter Magnetisierung möglich.

Ausführungsbeispiele

Die Erfindung soll in Ausführungsbeispielen und anhand von Figuren näher erläutert werden.
Die Figuren zeigen:

Fig. 1: Schematische Darstellung einer Vorrichtung zur Erzeugung und Detektion einer transienten Magnetisierung.
Fig. 2: Aufbau eines LC-VCO zur Verwendung in einer Vorrichtung zur Erzeugung und Detektion einer transienten Magnetisierung.
Fig. 3: Zeitlicher Verlauf der Steuerspannung $V_{tune}$ eines LC-VCO und die resultierende Änderung der Oszillationsfrequenz $\omega_{osc}$ des LC-VCO.
Fig. 4: Zeitlicher Verlauf der Steuerspannung $V_{tune}$ eines LC-VCO, resultierende Änderung im Magnetfeld $B_1$ des Schwingkreises des LC-VCO, resultierende Änderung der Orientierung der Magnetisierung $M_s$ der Probe, resultierende Änderung der effektiven Induktivität $\Delta L$ des Schwingkreises des LC-VCO und resultierende Änderung der Oszillationsfrequenz $\omega_{osc}$ des LC-VCO.
Fig. 5: Frequenzspektren der Magnetisierung der Probe $M_s$, der Oszillationsfrequenz $\omega_{osc}$ eines stromarmen LC-VCO und der Oszillationsspannung $V_{tune}$ des LC-VCO nach einem Anregungspuls des LC-VCO.
Fig. 6: Aufbau eines Abwärts-Frequenzumsetzer, der einem LC-VCO nachgeschaltet ist.
Fig. 7: Aufbau eines LC-VCO zur Verwendung in einer Vorrichtung zur Erzeugung und Detektion einer transienten Magnetisierung, erweitert durch eine spannungsgesteuerte Stromquelle.
Fig. 8: Aufbau eines LC-VCO zur Verwendung in einer Vorrichtung zur Erzeugung und Detektion einer transienten Magnetisierung, erweitert durch eine spannungsgesteuerte Stromquelle, die als digitale Stromsteuereinrichtung ausgeführt ist.
Fig. 9: a) Simulation der z-Komponente und der Einhüllenden der transversalen Magnetisierung einer auf einem Elektronenspin beruhenden Magnetisierung einer Probe in einer Spule eines spannungsgesteuerten LC-VCO während eines transienten Magnetfeldes mit Resonanzfrequenz und
b) Simulation der x-, y- und z-Komponenten während der letzten drei Nanosekunden des transienten Magnetfeldes.
Fig. 10: Simulation des Verlaufs der Magnetisierung $M_z$ und des Betrags der Einhüllenden der transversalen Magnetisierung $|M_T|$ für einen Puls mit der Dauer $\tau$ = 4,436 ns (ca. 90° Puls)
Fig. 11: Simulation der spektralen Leistungsdichte der Oszillatorausgangsspannung nach einem Pulse der Dauer $\tau$ = 4,436 ns
Fig. 12: Spektrum der Figur 11 nach digitaler Frequenzdemodulation und Tiefpassfilterung (Simulation).

Fig. 13: Spektrum der Figur 11 nach Amplitudendemodulation (Simulation).
Fig. 14: a) LC-VCO eingebunden in einen Phasenregelkreis mit zwei Referenzoszillatoren und
b) mit vier Referenzoszillatoren .

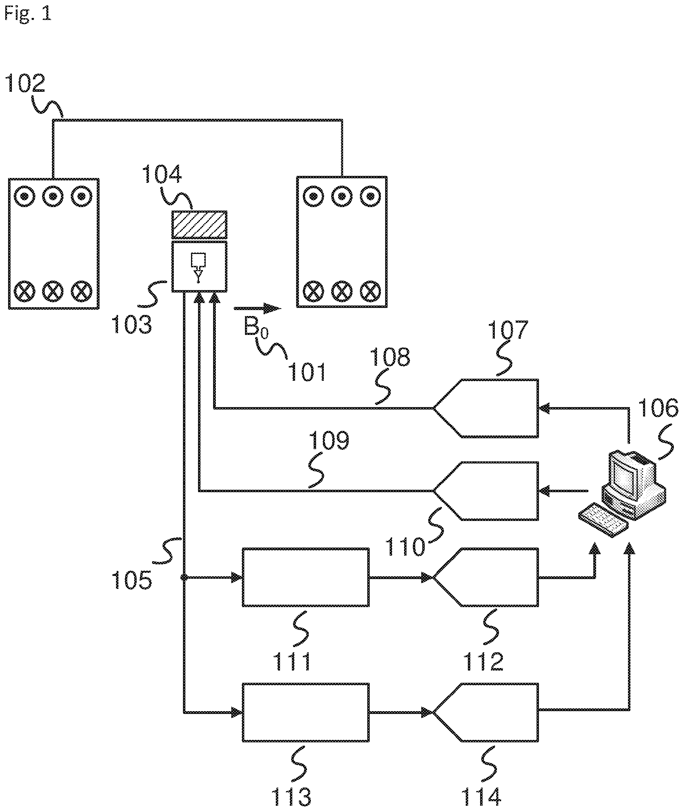

In der Fig. 1 ist eine schematische Darstellung einer erfindungsgemäßen Vorrichtung zur Erzeugung und Detektion einer transienten Magnetisierung gezeigt. Ein Magnet **102,** der zum Beispiel ein supraleitender Magnet, ein Elektromagnet beliebiger Ausführung oder ein Permanentmagnet sein kann, erzeugt das statische Magnetfeld $B_0$ **101** an einem Probenort, an dem eine Probe **104** angeordnet ist. Das Magnetfeld $B_0$ **101** induziert in der Probe **104** eine Magnetisierung entsprechend der Suszeptibilität der Probe **104**. Ein LC-Oszillator **103** erzeugt ein transientes Magnetfeld $B_1$. Der LC-Oszillator **103** wird angesteuert durch eine zeitabhängige Wellenform, die als Steuerspannung $V_{(tune,\omega_{osc})}$**108** dient, durch welche die Frequenz des Oszillators **103** bestimmt ist, und eine zweite zeitabhängige Wellenform, die zur Manipulation der Amplitude der Oszillation des LC-Oszillators **103** dient $V_{(tune,A_{osc})}$ **109**. Die zeitabhängigen Wellenformen werden hier durch einen Personal Computer/digitale Datenverarbeitungsvorrichtung **106** bereitgestellt und durch Digital-Analog-Umsetzer **107 / 110** konvertiert. Die Ausgangsspannung $V_{(osc,out)}$ **105** des LC-Oszillaotrs **103** wird FM- und AM-Demodulatoren **111/113** zugeführt, durch Analog-Digital-Umsetzer **112/114** konvertiert und dann einer Datenverarbeitungsvorrichtung **106** übergeben, auf der Mittel zur Bestimmung spektraler Komponenten der Magnetisierung der Probe auf Grundlage eines physikalischen Modells transienter Induktivität und transienten Widerstands einer Spule bereitgestellt sind und von der aus die ermittelten Werte für die spektralen Komponenten der Probe mit einem geeigneten Mittel (nicht gezeigt) ausgegeben werden. Durch die Datenverarbeitungsvorrichtung sind hier somit zwei Mittel, Mittel zur Ansteuerung des LC-Oszillators und Mittel zur digitalen Datenverarbeitung, realisiert, die auch separat ausgeführt werden können.

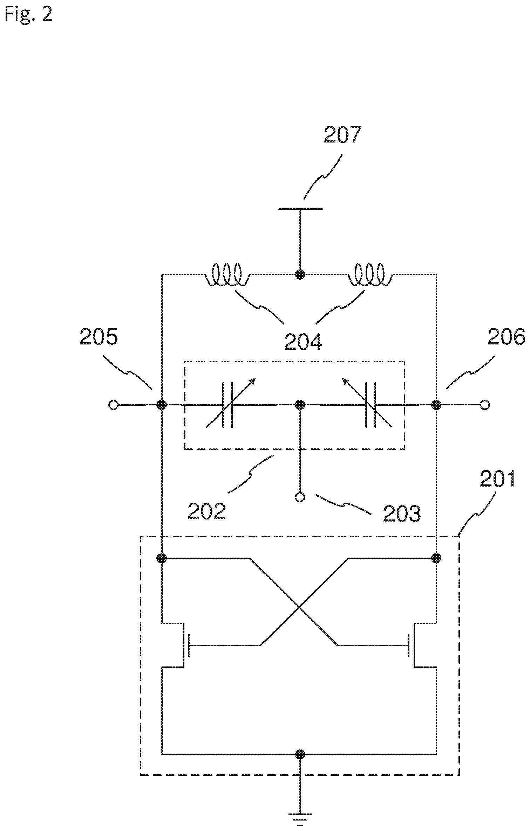

In der Fig. 2 ist der Aufbau eines LC-VCO zur Verwendung in einer erfindungsgemäßen Vorrichtung zur Erzeugung und Detektion einer transienten Magnetisierung gezeigt, wie er auch einer Ausführungsform entspricht. Eine differentielle Kapazitätsdiode (Varaktor) **202** und eine differentielle Induktivität **204** dienen zur Bildung des LC-Schwingkreises. Zwei kreuzgekoppelte Transistoren **201** gewährleisten eine stabile Oszillation im differentiellen Output (d.h. der Ausgangsspannung) durch negativen Widerstand und Nichtlinearität zwischen zwei Knotenpunkten **205 / 206.** Die Abstimmungseigenschaften werden durch die differentielle Kapazitätsdiode **202** mit der Steuerspannung **203** gewährleistet. Die zeitabhängige Variation der Oszillationsamplitude wird z.B. umgesetzt durch eine Manipulation der Spannungsversorgung des LC-VCO. Die Oszillationsamplitude wird durch die Modulation der Versorgungsspannung **207** realisiert. Diese einfache Ausführung eines LC-VCO gewährleistet eine geringe Leistungsaufnahme, geringen Platzbedarf und arbeitet zudem auch bei niedrigen (bis zu kryogenen) Temperaturen.

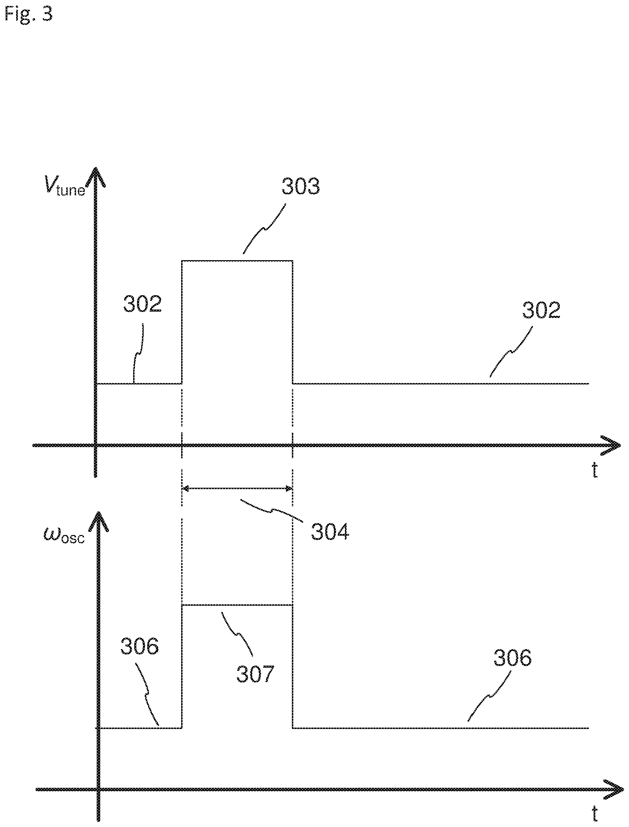

Die Auswirkungen einer zeitabhängigen Wellenform, die eine Änderung mit der Zeitdauer $\tau_{puls}$ **304** in der Spannung beinhaltet und die als Steuerspannung in einen LC-Oszillator eingespeist wird, ist in Fig. 3 gezeigt. Die Steuerspannung $V_{tune}$ wird in Folge zwischen den Werten $V_{tune1}$ **302** und $V_{tune2}$ **303** geschaltet und erzeugt eine zugehörige Änderung in der freien Oszillationsfrequenz $\omega_{osc0}$ des LC-Oszillators, sowohl der oszillierenden Spannung als auch des Stroms, der durch die Spule des LC-Oszillators läuft. Die Oszillationsfrequenz wird in Folge mit einer Zeitdauer annähernd $\tau_{puls}$ zwischen den Werten $\omega_{osc1}$ **306** und $\omega_{osc2}$ **307** geschaltet. Als freie Oszillationsfrequenz ist die Oszillationsfrequenz definiert, bei der der Oszillator ohne den Einfluss, der durch die Probe im angeregten Zustand induziert wird, schwingt.

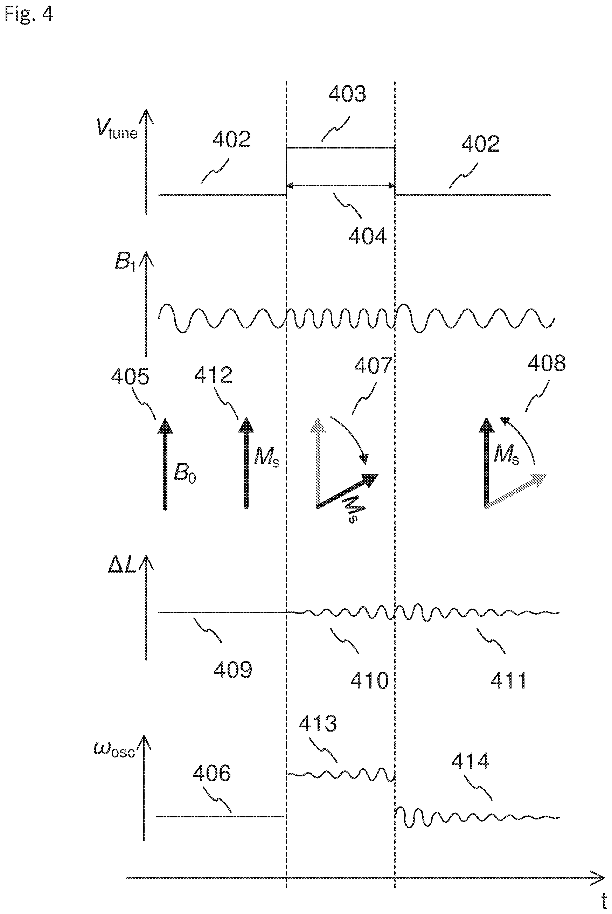

Die zeitlichen Verläufe der Steuerspannung $V_{tune}$, $V_{tune1}$ **402** und $V_{tune2}$ **403,** eines LC-Oszillators, die eine Änderung mit der Zeitdauer $\tau_{puls}$ **404** in der Spannung beinhaltet, die daraus resultierende Änderung im Magnetfeld $B_1$ (transientes Magnetfeld) des Schwingkreises des LC-Oszillators sind in den oberen beiden Teilbildern der Fig. 4 dargestellt. Die resultierende Änderung der Orientierung der Magnetisierung $M_s$ **412, 407** und **408** der Probe ist im darunter liegenden Teilbild dargestellt. In den beiden unteren Teilbildern der Fig. 4 sind die entsprechenden Verläufe der resultierenden Änderung der effektiven Induktivität $\Delta L$ **409, 410** und **411** des Schwingkreises des LC-Oszillators und der resultierenden Änderung der Oszillationsfrequenz $\omega_{osc}$ **406, 413** und **414** des LC-Oszillators gezeigt. Die Darstellung der an einem Messvorgang beteiligten Parameter bezieht sich auf eine gemeinsame Zeitachse, um die Zusammenhänge zu veranschaulichen. Zusätzlich ist außerdem die Orientierung von $B_0$ **405** gezeigt. $V_{tune1}$ **402** und $V_{tune2}$ **403** entsprechen den durch die zeitabhängige Wellenform, die eine Änderung mit der Zeitdauer $\tau_{puls}$ **404** in der Spannung beinhaltet, geschalteten Steuerspannungen aus der Fig. 3. Die Änderung im Magnetfeld $B_1$ des Schwingkreises des LC-Oszillators bewirkt eine Änderung der Magnetisierung $M_s$ **412, 407** und **408** der Probe, welche in einem sogenannten "rotating frame of reference" (Referenzsystem der Rotation) dargestellt ist, das aus $B_0$ **405** induziert wird, wozu die Rotationsgeschwindigkeit des "Rotating frame of reference" zu $-\gamma \cdot B_0$ gewählt ist. Die Änderung in der Magnetisierung $M_s$ der Probe wird detektiert über die korrespondierende Änderung in der Frequenz der Oszillation, wobei die Oszillation dann einer Frequenz des Oszillators $\omega_{osc,\chi}$ bei Einfluss durch Probenmagnetisierung entspricht, **413/414.**

Die Änderung in der Steuerspannung, mit der Dauer $\tau_{pulsE}$ **404,** bewirkt eine korrespondierende Änderung in der Frequenz des Magnetfeldes $B_1$, welches von der Spule des LC-Oszillators generiert wird. Die Steuerspannungen $V_{tune1}$ **402** und $V_{tune2}$ **403** sind dabei so gewählt, dass die Steuerspannung $V_{tune1}$ **402** eine freie Oszillatorfrequenz **406** bewirkt, die einen genügend großen Abstand zur Resonanzfrequenz hat, die sich aus der Magnetisierung der Probe und dem statischen Magnetfeld $B_0$ **405** ergibt, und andererseits keinerlei Anregung in der Probe bewirkt. Außerdem bewirkt die Steuerspannung $V_{tune2}$ **403** eine Frequenz, die der Resonanzfrequenz entspricht bzw. nahe genug an dieser liegt, um eine Anregung während der Zeitdauer $\tau_{puls}$ **404** zu bewirken. Die Probenmagnetisierung $M_s$ wird durch die Anregung während der Zeitdauer $\tau_{puls}$ **404** aus ihrer Gleichgewichtslage entlang der Richtung des $B_0$-Feldes **405** gekippt und beginnt mit der Lamorfrequenz zu präzedieren. Gemäß den Ausführungen in dem Abschnitt 1 der Einführung des neuen Modells (siehe oben unter Aufgabenstellung), führt dies zu einer korrespondierenden Änderung der Induktivität $\Delta L$ des LC-Oszillators während der Anregung. Dabei ändert sich die Oszillationsfrequenz $\omega_{osc}$ um einen Betrag, der der Änderung in der Steuerspannung entspricht und dem die Änderung, welche verursacht ist durch die Änderung in $\Delta L,$ überlagert ist und die dann einem $\omega_{osc,\chi}$ entspricht, **413.** Nach der Anregung präzediert die Magnetisierung $M_s$ der Probe weiter um die Achse des Feldes $B_0$ **405** und relaxiert zurück in die Gleichgewichtslage. Daraus resultiert eine Änderung in der Induktivität der Spule $\Delta L$ auch nach der Anregung, welche eine korrespondierende Änderung in der Oszillationsfrequenz $\omega_{osc}$ **414** des LC-Oszillators bewirkt, die dann ebenfalls einer Frequenz des Oszillators bei Einfluss durch die Probenmagnetisierung $\omega_{osc,\chi}$ entspricht.

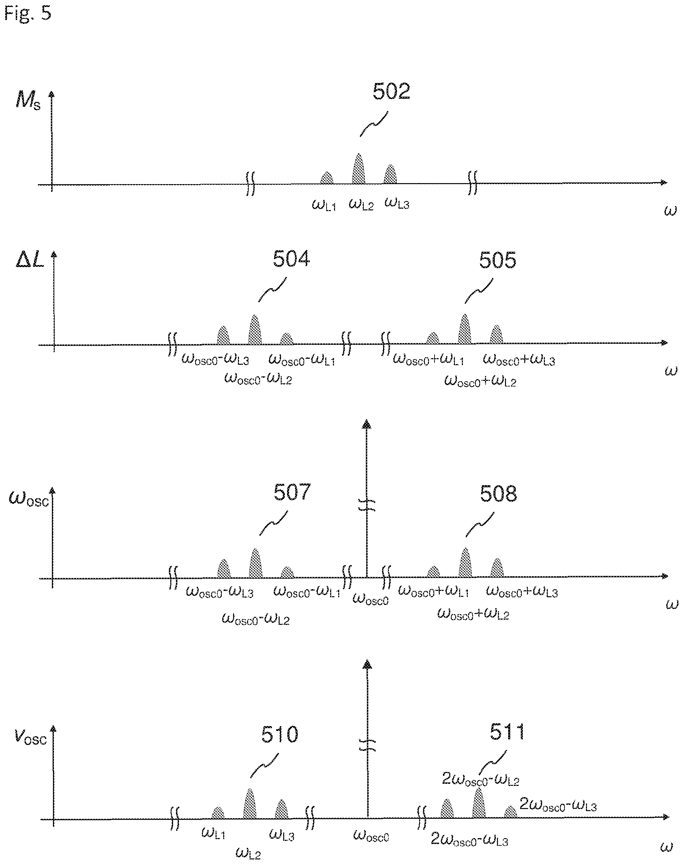

Die Fig. 5 zeigt die Spektren einer spinbasierten Magnetisierung $M_s$ einer Probe, der korrespondierende Änderungen der Induktivität $\Delta L_{sample}$ der Spule des LC-Oszillators, der resultierenden Oszillationsfrequenz $\omega_{osc}$ und der Frequenz $v_{osc}$ der zugehörigen Steuerspannung $V_{tune}$ nach einer Anregung, korrespondierend zu dem Zeitabschnitt

nach $\tau_{puls}$ **404** in Fig. 4. Die Darstellung bezieht sich auf eine gemeinsame Frequenzachse, um die Zusammenhänge zu veranschaulichen. Die Darstellung der Spektren basiert auf der Annahme, dass sich die spinbasierte Magnetisierung aus drei verschiedenen Spinensembles mit drei verschiedenen $g$-Faktoren zusammensetzt, was ein Spektrum der präzedierenden Magnetisierung mit drei verschiedenen Spektrallinien bei den Frequenzen $\omega_{L1,2,3}$ **502** bewirkt. Die Frequenzen $\omega_{L1,2,3}$ stimmen mit den Frequenzen der spektralen Komponenten der Probenmagnetisierung $\omega_i$ überein, die hier Lamorfrequenzen entsprechen. Gemäß den Ausführungen im Abschnitt 1 der Einführung des neuen Modells (siehe oben unter Aufgabenstellung) induziert die präzedierende Magnetisierung der Probe eine Änderung der effektiven Induktivität des LC-Oszillators. Diese Induktivitätsänderung weist Frequenzanteile bei der Summe und der Differenz der Frequenzen der präzedierenden Magnetisierung und der freien Oszillationsfrequenz nach der Anregung gemäß $\omega_{osc0} \pm \omega_{L1,2,3}$ **504/505** auf. Die korrespondierenden Oszillationsfrequenzen $\omega_{osc}$ gemäß $\omega_{osc0} \pm \omega_{L1,2,3}$ sind ebenfalls gezeigt **507/508.**

Gemäß Gleichung (1.11a) und (1.11b) (siehe oben) resultiert die Änderung der Induktivität der Spule im probenbezogenen Anteil $\Delta L_{sample}$ in einer näherungsweise proportionalen Änderung der Oszillationsfrequenz $\omega_{osc}$ der Spule. Daher enthält das Spektrum dieser Oszillationsfrequenz $\omega_{osc}$ Spektrallinien bei den gleichen Frequenzen wie denen im Spektrum der detektierten Induktivitätsänderungen der Probe von $\Delta L_{sample}$. Diese Spektrallinien sind um eine große, zentrale Spektrallinie bei der freien Oszillationsfrequenz $\omega_{osc0} = w_{osc}(V_{tune1})$ gruppiert. Die kleineren Spektrallinien, die aus der Magnetisierung der Probe resultieren, bewirken eine schwache Modulation der Oszillationsfrequenz der korrespondierenden Spannung $v_{osc}$ des LC-Oszillators. Die Spektrallinien im Spektrum von $v_{osc}$ liegen demnach bei

$$\omega_{\mathrm{osc0}} - \left(\omega_{\mathrm{osc0}} - \omega_{L1,2,3}\right) = \omega_{L1,2,3}$$

**510** und

$$\omega_{\mathrm{osc0}} + \left(\omega_{\mathrm{osc0}} - \omega_{L1,2,3}\right) = 2 \cdot \omega_{\mathrm{osc0}} - \omega_{L1,2,3}$$

**511**.

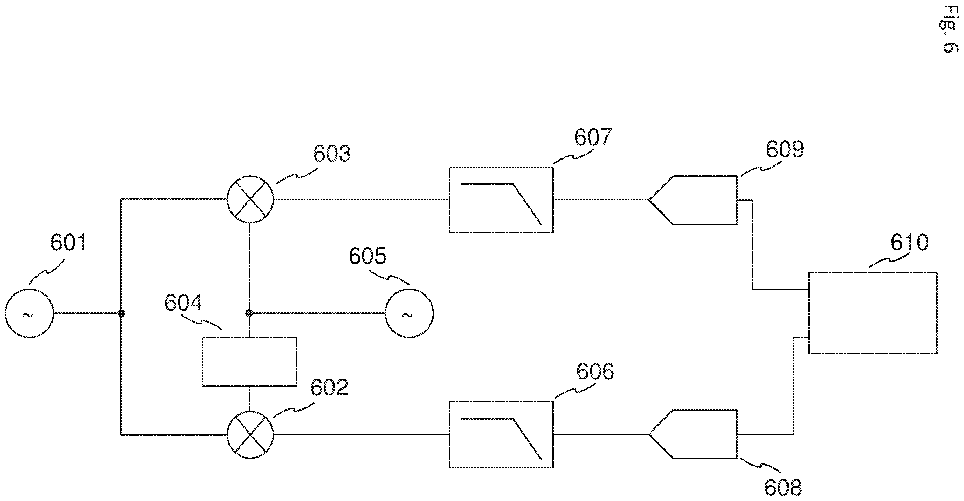

Abhängig von der zu erfassenden Probenmagnetisierung, den experimentellen Bedingungen und der freien Oszillationsfrequenz $\omega_{osc0}$ nach der Anregung der Probe können die spektralen Komponenten der Oszillation der Spannung des LC-Oszillators bei Frequenzen liegen, die eine direkte Demodulation erschweren oder ineffizient machen kann. Zusätzlich können die spektralen Komponenten aus der Änderung der Induktivität $\Delta L_{sample}$ bei Frequenzen liegen, die modulierte Frequenzen der freien Oszillatorfrequenz erzeugen, welche weniger als eine Oktave von der freien Oszillationsfrequenz entfernt liegen und somit eine "single cycle Demodulation", also eine Demodulation innerhalb einer Schwingung der Trägerperiode der Oszillation der Spannung benötigen, um die Information über die Magnetisierung der Probe zu erhalten. Die single-cycle Demodulation lässt sich vereinfacht digital durchführen, wenn der interessierende spektrale Ausschnitt der Oszillation der Spannung digitalisiert ist. Bedingt durch die begrenzte Bandbreite und das begrenzte Auflösungsvermögen existierender Analog-Digital-Umformer, benötigt die Demodulation daher gegebenenfalls eine vorherige Absenkung der zentralen Frequenz der Oszillation der Spannung von den möglicherweise erhöhten Werten für $\omega_{osc1}$ zu niedrigeren Frequenzen. Dies kann z.B. durch Frequenzteiler oder Frequenzmischer realisiert werden. Um sicherzustellen, dass dabei keine Information verlorengeht, wird ein Abwärtsmischer mit Quadraturpfaden zur Verarbeitung der Ausgangsspannung des LC-Oszillators **601** diesem nachgeschaltet, wie es in Fig. 6 gezeigt ist und einer Ausführungsform entspricht. Der Abwärtsmischer mit Quadraturpfaden ist aufgebaut aus I- und Q-Pfad-Mischern **602/603,** die betrieben werden mit einer geeigneten Frequenz $\omega_{VCO2}$ eines Referenzoszillators **605,** von der aus eine Quadraturversion, z.B. mit einem 90°-Phasenschieber **604,** erzeugt werden kann. Die heruntergeregelte und gefilterte Oszillationsfrequenz der Spannung kann dann mit gebräuchlichen Analog-Digital-Umformern **608/609** zu einer Einrichtung **610** zwecks Weiterverarbeitung in digitaler Darstellung digitalisiert werden. Vor der Analog-Digital-Umformung wird die Bandbreite durch sogenannte Anti-Aliasing-Filter **606/607** begrenzt, wodurch Artefakte, die auf dem Alias-Effekt beruhen, herausgefiltert werden.

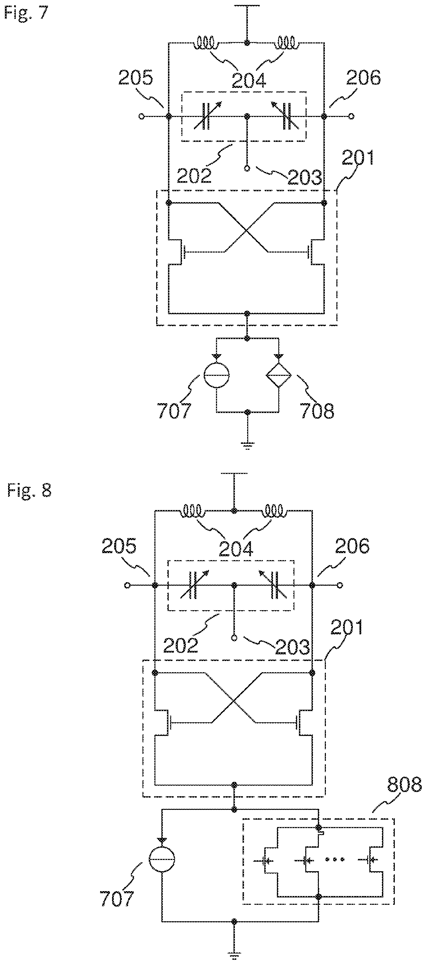

In Fig. 7 sind zwei Beispiele für eine Ausführung zur Implementierung einer präzisen Kontrolle der Oszillationsamplitude der Spule des LC-Oszillators gezeigt, die eine spannungsgesteuerte Stromquelle **708** parallel zu einem fixierten Vorstrom (BiasStrom) **707** aufweist. In dieser Ausführung wird die zeitabhängige Wellenform, die zur Manipulation der Amplitude der Oszillation des LC- Oszillators dient, in die spannungsgesteuerte Stromquelle eingespeist, um eine Einhüllende des transienten Magnetfeldes, das in der Spule des LC-Oszillators erzeugt wird, den Anforderungen der Probe und des Experiments gemäß zu optimieren.

In Fig. 8 ist gezeigt, wie die spannungsgesteuerte Stromquelle **708** in der Fig. 7 effizient als Hochgeschwindigkeits-Strom-modus Digital-Analog-Umformer **808** (high-speed current mode digital-to-analog-converter) implementiert werden kann.

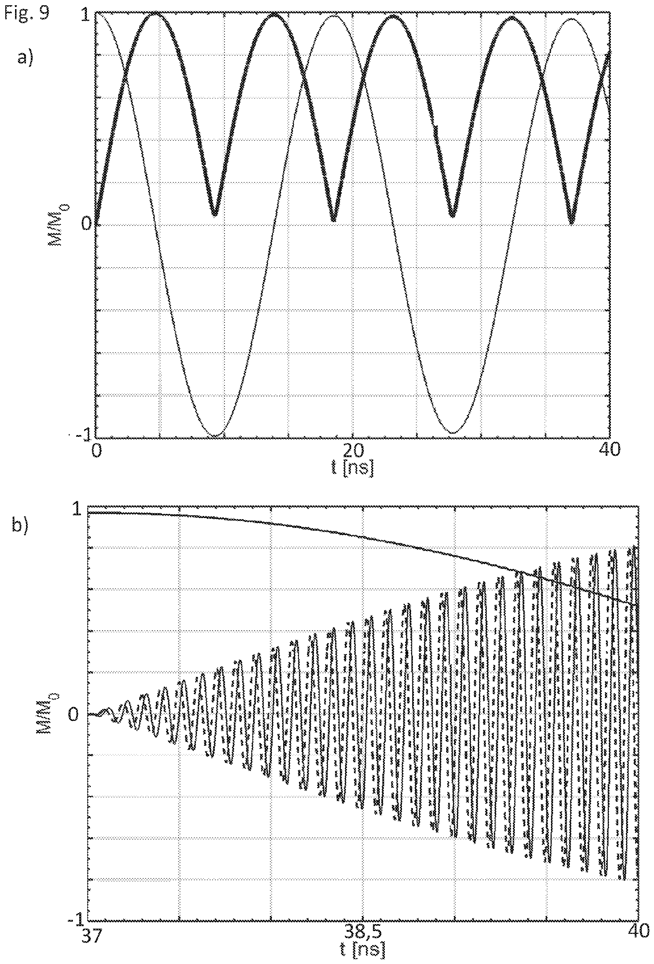

Um das Arbeitsprinzip der erfindungsgemäßen Vorrichtung und des erfindungsgemäßen Verfahrens zur Erzeugung und Detektion einer transienten Magnetisierung einer Probe zu illustrieren, sind in den Figuren 9 bis 13 Simulationen einer Magnetisierung einer Probe und zugehörige Signale gezeigt. Die Simulationen basieren auf dem neuen vorn beschriebenen Modell transienter Induktivität und transienten Widerstands einer Spule, das zur Ermittlung der ursprünglichen Spektrallinien einer Probe dient, wobei die Signale aus einem Experiment mit der erfindungsgemäßen Probe oder aus dem erfindungsgemäßen Verfahren stammen. Die Magnetisierung der Probe basiert dabei auf zwei unterschiedlichen Spinensembles, mit zwei unterschiedlichen zugehörigen $g$-Faktoren. Die Simulationen sind sowohl für eine Zeitdauer während des Anliegens eines transienten Magnetfeldes (Anregung) als auch für eine Zeitdauer nach der Anregung berechnet. Die Parameter sind dabei wie folgt vorausgesetzt: $g$-Faktor des ersten Spinensembles $g_1 = 2$ , $g$-Faktor des zweiten Spinensembles $g_2 = 2{,}025$, Gleichgewichtsmagnetisierung ($M_{s0}$) des ersten Spinensembles

$M_{s0g1} = 7{,}3$ A/m, Gleichgewichtsmagnetisierung des zweiten Spinensembles $M_{s0g2} = 8{,}1$ A/m, Relaxationszeiten für beide Spinensembles $T_1 = T_2 = 10$ μs, statisches Magnetfeld $B_0 = 0{,}35$ T, freie Oszillationsfrequenz $\omega_{osc0} = 21{,}74$ GHz und Oszillationsfrequenz während der Anregung $\omega_{osc2} = 9{,}56$ GHz.

Fig. 9 a) zeigt die Entwicklung der longitudinalen Magnetisierung $M_z$ (—) und die der Einhüllenden $|M_T|$ (—) der transversalen Komponenten ($M_x$ und $M_y$) einer Probe während der Zeitdauer, in der eine zeitabhängige Wellenform in Form eines Rechteckpuls (40 ns), wie in Fig. 3 gezeigt, in den erfindungsgemäßen LC-Oszillator eingespeist und die Probe am Probenort angeordnet ist (Simulation). Dabei ist der Rechteckpuls so gewählt, dass die freie Oszillationsfrequenz der Spule des LC-Oszillators, die vor dem Rechteckpuls in der Spule vorliegt, genügend weit von der Resonanzfrequenz der Probe entfernt liegt, um deren Magnetisierung nicht zu beeinflussen. Außerdem entspricht die Frequenz während des Rechteckpulses der Resonanzfrequenz der Probe oder ist annähernd so groß, um die Magnetisierung de Probe zu beeinflussen. Die Zeitdauer der Anregung (Dauer des Rechteckpulses) ist dabei so gewählt, dass mehrere Rabi-Oszillationen beobachtet werden können, sodass der finale Vektor der Magnetisierung der Probe einer transversalen Magnetisierung entspricht, welche detektiert wird. In Fig. 9b) ist der Verlauf der Komponenten $M_z$ (...), $M_y$ (— —) und $M_z$ (—) während der letzten drei Sekunden der Anregung gezeigt.

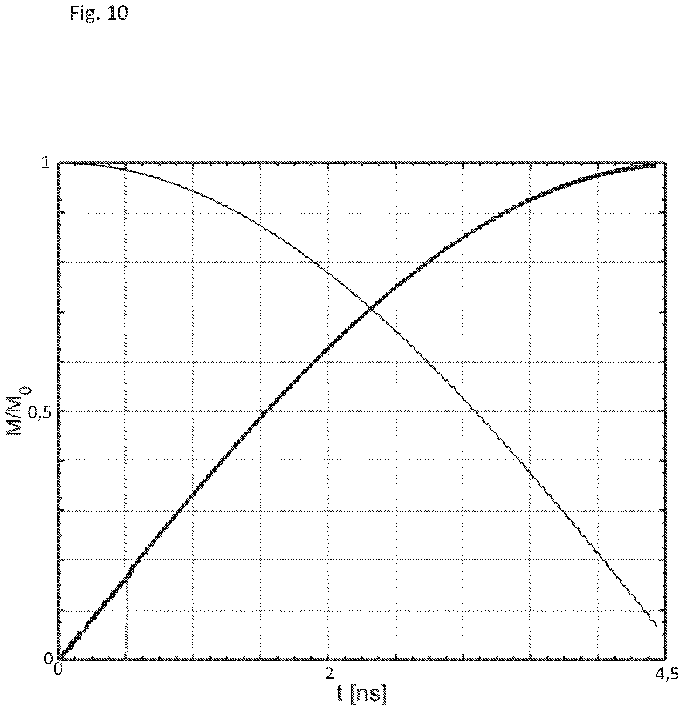

Die Simulation des Verlaufs der Magnetisierung $M_z$ (—) und des Betrags der Einhüllenden der transversalen Magnetisierung $|M_T|$ (—) für einen Puls mit der Dauer $\tau = 4{,}436$ ns (ca. 90° Puls) ist in der Fig. 10 gezeigt.

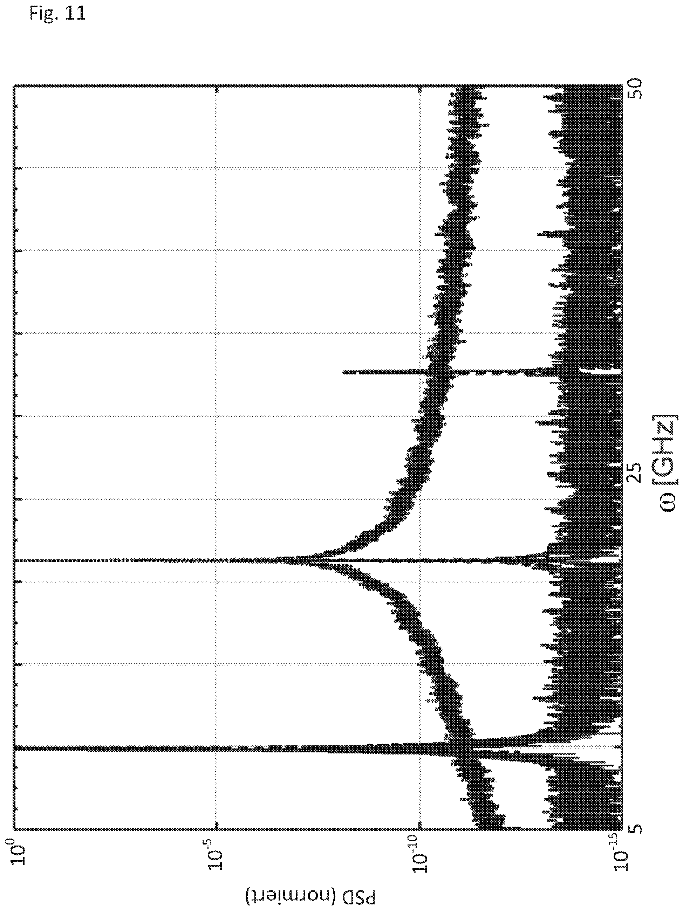

Das zur Fig. 10 zugehörige simulierte Spektrum der spektralen Leistungsdichte (PSD, power spectral density) der Oszillatorausgangsspannung nach einem Pulse der Dauer $\tau = 4{,}436$ ns ist in der Fig. 11 gezeigt.

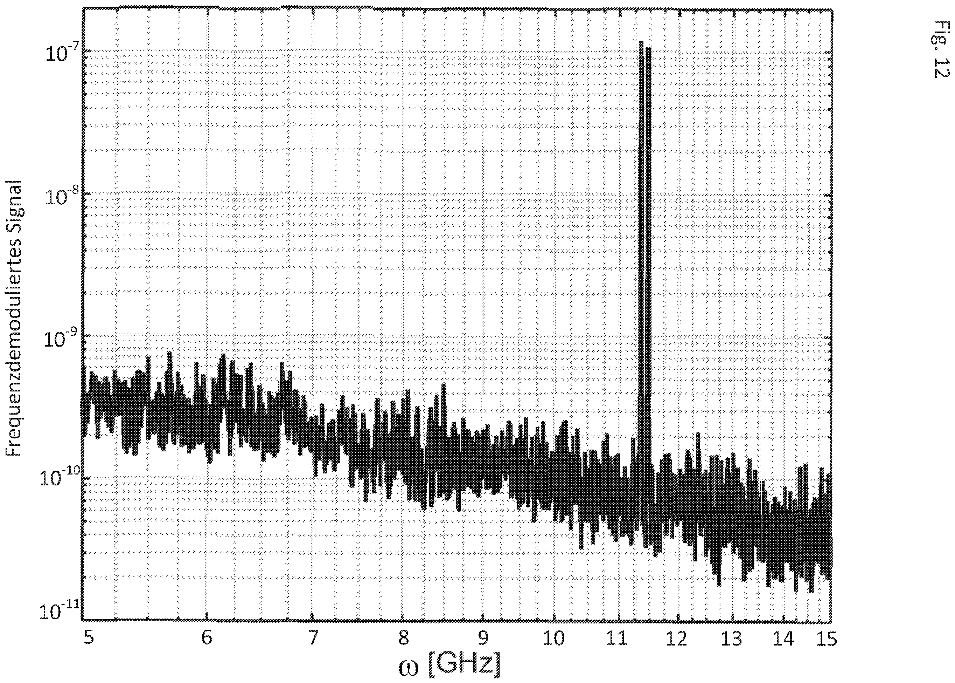

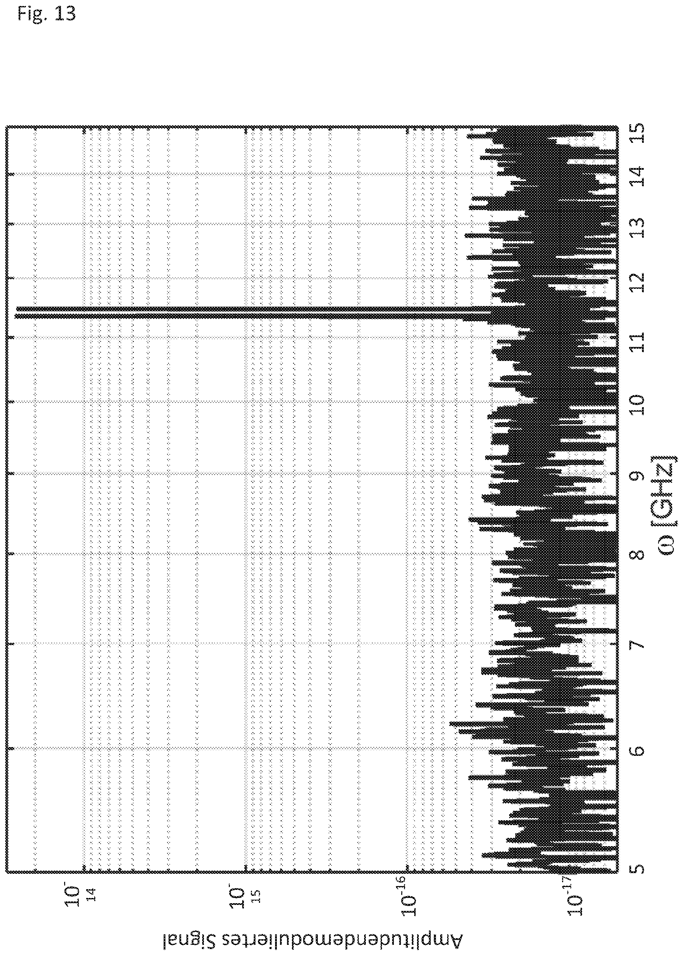

Die Fig. 12 und Fig. 13 zeigen die korrespondierenden FM- und AM-demodulierten Signale, welche aus der Fig. 11 folgen.

Die Frequenzen nach Pulsanregung und Demodulation entsprechend den Figuren 12 und 13, die als Signale auslesbar sind (und zur Datenverarbeitung weitergeleitet werden) und auf einer freien Oszillationsfrequenz von

$$\frac{\omega_{osc0}}{2\pi} = 21{,}76 \text{ GHz}$$

und den $g$ - Faktoren der Probe $g_1 = 2$ und $g_2 = 2{,}025$ basieren - aus denen sich die Larmorfrequenzen zu

$$\frac{\omega_{L1}}{2\pi} = 9{,}7974 \text{ GHz} \quad \text{und} \quad \frac{\omega_{L1}}{2\pi} = 9{,}9198 \text{ GHz}$$

ergeben -, entsprechen genau den spektralen Komponenten (Anregung mit dem arithmetischen Mittel der beiden Larmorfrequenzen) nach der Demodulation

$$\frac{\omega_{osc0} - \omega_{L1}}{2\pi} = 11{,}4786 \text{ GHz} \quad \text{und} \quad \frac{\omega_{osc0} - \omega_{L2}}{2\pi} = 11{,}3562 \text{ GHz}.$$

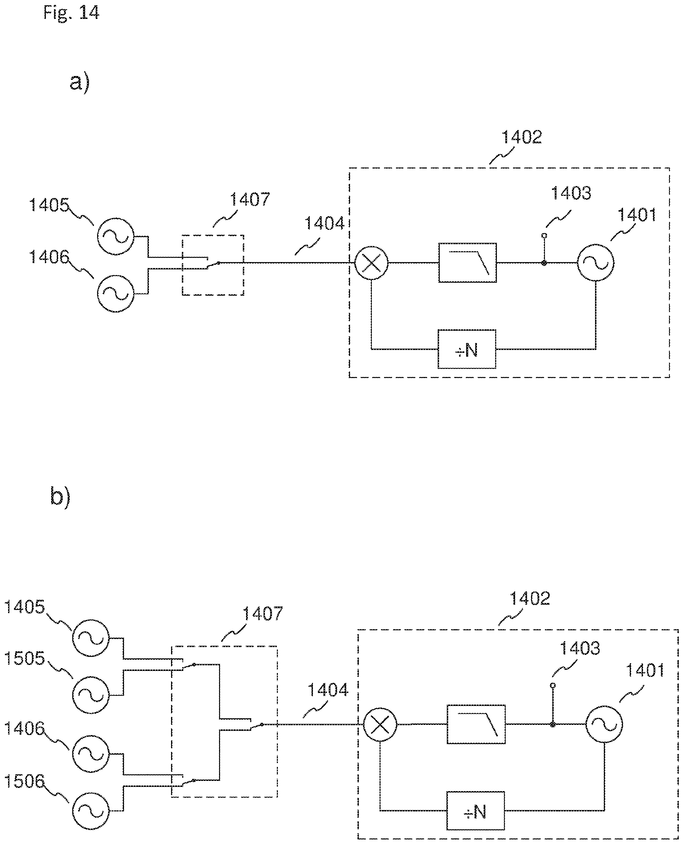

Ein erfindungsgemäßer LC-VCO **1401**, eingebunden in Phasenregelschleifen **1402**, ist in Fig. 14 a) und b) gezeigt. Die Phasenregelschleifen **1402** garantieren, dass bei einer Folge von Anregungspulsen (transiente Magnetfelder) in einem ESR- oder NMR-Experiment die Phaseninformation aufeinanderfolgender Pulse nicht zwischen dem Schalten des LC-VCO **1401,** zwischen einer anregenden Frequenz in der Nähe von oder gleich der Resonanzfrequenz und einer von dieser entfernten Frequenz verloren geht. Die Phasenkohärenz wird gewährleistet, indem eine Referenzfrequenz $\omega_{ref}$ **1404** aus zwei verschiedenen Quellen (Oszillatoren **1405, 1406**) gewählt werden kann, die kontinuierlich bei einer Frequenz $\omega_{res}/N$ bzw. $\omega_{off}/N$ läuft, mit $N$ = Teilungsfaktor der Phasenregelschleife **1402,** $\omega_{res}$ - einer Frequenz in der Nähe von oder gleich der Resonanzfrequenz und $\omega_{off}$ - einer von der Resonanzfrequenz entfernten Frequenz. Die Auswahl zwischen den beiden Frequenzen erfolgt mithilfe eines geeigneten Multiplexers **1407.** Wenn die Referenzfrequenz **1404** der Phasenregelschleife **1402** zwischen $\omega_{off}/N$ und $\omega_{res}/N$ geschaltet wird, wechselt die Frequenz des LC-VCO **1401** in der Phasenregelschleife **1402** durch die negative Rückführung in der Phasenregelschleife **1402** entsprechend zwischen $\omega_{off}$ und $\omega_{res}$. Da die Oszillatoren **1405/1406,** die als Quellen dienen, kontinuierlich bei den gleichen Frequenzen laufen, d.h. sie ändern diese nicht, ändert sich ihre Phase auch nicht zwischen zwei Zeitspannen, in denen ihre Frequenz in den LC-VCO eingespeist wird, was besonders für die Zeitspannen für $\omega_{res}$ von Bedeutung ist. Da die Phasenregelschleife **1402** durch ihre negative Rückführstruktur die Phase des VCOs **1401** mit der Phase des Referenzoszillators abgleicht, wird (unter Vernachlässigung von kurzen Einschwingvorgängen) gewährleistet, dass eine Folge von Anregungspulsen kohärent bzgl. ihrer Phase ist. Um darüber hinaus einen kohärenten Wechsel in Folgen von Anregungspulsen und verschiedenen Pulssequenzen (phase cycling) zu gewährleisten, kann die Schaltung gemäß der Fig. 14a) erweitert werden auf die der Fig. 14b). In der erweiterten Schaltung sind zwei zusätzliche Quellen **1505/1506** für Referenzfrequenzen zugefügt, die mit einem 90° Phasenunterschied zu den Quellen aus Fig. 14a) laufen. So wird eine Anregung in der x'- und y'-Richtung des rotierenden Koordinatensystems (rotating frame of reference) ermöglicht. Die Schaltung kann außerdem erweitert werden, um Anregungen weiterer Richtungen zu ermöglichen, indem weitere Quellen für Referenzfrequenzen mit entsprechenden Phasenunterschieden hinzugefügt werden. Ausgänge **1403,** an denen direkt frequenzdemodulierte Signale abgreifbar sind, sind zusätzlich vorgesehen.

Abkürzungsverzeichnis

| | | |
|---|---|---|
| $A_{osc}$ | Oszillationsamplitude eines LC-Oszillators | |
| $B$ | Magnetfeld | |
| $B_0$ | statisch homogenes, statisch inhomogenes oder dynamisches (gepulst inhomoges) Magnetfeld | |
| $B_1$ | zusätzliches, hochfrequentes, elektromagnetisches Wechselfeld / Magnetfeld; zur Anregung genutzt, kann als in einer Eigenschaft zeitlich begrenztes, transientes Feld vorliegen | |
| $\vec{B}_u$ | unitäres Magnetfeld | |
| $C$ | Kapazität | |
| $\vec{e}_{\parallel}$ | Einheitsvektor in Richtung des $B_0$-Feldes | |
| $E_1$ | elektrisches Feld | |
| $G_m$ | Steilheit (Transkonduktanz) des aktiven Transistors, der den negativen Widerstand bewirkt, welcher als Stabilisierung der Oszillation dient | |
| $G_t$ | Leitwert des Schwingkreises | |
| $h$ | Plancksches Wirkungsquantum | |
| $H_1$ | magnetische Feldstärke | |
| $i(t)$ | zu $v(t)$ zugehörige Stromfluss | |
| $I_{BIAS}$ | DC-Ruhestrom des Oszillators (Biasstrom) | |
| $J$ | Stromdichte | |
| $\vec{L}$ | Bahndrehimpuls | |
| $L_0$ | von der Probe unabhängiger Ausdruck der Induktivität der Spule, gegeben durch deren Geometrie | |
| $L_{\text{eff}}$ | effektive Induktivität | |
| $L(t)$ | zeitlich veränderliche Induktivität, verknüpft mit dem magnetischen Feld in einer Spule | |
| $\Delta L_{\text{sample}}(t)$ | detektierbare Induktivitätsänderung der Probe im transienten Magnetfeld | |
| $\Delta L_{\text{sample,CW}}(t)$ | detektierbare Induktivitätsänderung der Probe im Dauerstrichexperiment | |
| $\vec{M}$ | makroskopische Magnetisierung, Magnetisierung der Probe | |
| $M_s$ | spinbasierte Magnetisierung | |
| $M_{s\parallel}$ | longitudinale spinbasierte Magnetisierung in Bezug auf $B_0$ | |
| $M_{s\perp}$ | transversale spinbasierte Magnetisierung in Bezug auf $B_0$ | |
| $M_{s0}$ | Gleichgewichtszustand der spinbasierten Magnetisierung | |
| $M_x$ | Magnetisierung eines Spinensembles | |
| $n$ | Emissionsfaktor im Unterschwellenbereich | |
| $P$ | Leistung | |
| $r$ | Abstandsvektor vom Ursprung für eine Integration über das Volumen | |
| $R_0$ | ohmscher Spulenwiderstand | |
| $R_{\text{eff}}$ | effektiver Widerstand der Spule | |
| $R_{\text{sample,tot}}$ | durch die Probe induzierter Spulenwiderstand | |
| $R_{\text{sample}}(t)$ | zeitlich veränderlicher Verlust in der Spule, welcher durch die Magnetisierung der Probe verursacht wird | |
| $t$ | Zeit | |
| $T_1$ | Relaxationszeit | |
| $T_2$ | Spin-Spin-Relaxationszeit | |
| $v(t)$ | Spannungsverlust über eine Spule | |
| $V$ | Volumen | |
| $V_s$ | Probenvolumen | |
| $w_m$ | Energiedichte pro Volumeneinheit | |
| $W_m$ | totale magnetische Energie, verknüpft mit der Induktionsspule | |

| | |
|---|---|
| $\gamma$ | gyromagnetisches Verhältnis |
| $\varepsilon_0$ | elektrische Feldkonstante |
| $\eta$ | Füllfaktor |
| $\theta$ | Kippwinkel der Magnetisierung |
| $\vec{\mu}$ | magnetisches Dipolmoment |
| $\mu_B$ | Bohrsches Magneton |
| $\mu_r$ | relative Permeabilität der Probe |
| $\mu_0$ | magnetische Feldkonstante |
| $\vec{\tau}$ | Drehmoment |
| $\tau_{puls}$ | Zeitdauer des Anlegens des resonanten $B_1$-Feldes (transientes Feld, anregendes Feld, Puls) |
| $\omega$ | Kreisfrequenz |
| $\omega_{osc}$ | Frequenz des Oszillators |
| $\omega_{osc0}$ | freie Frequenz des Oszillators = Frequenz der magnetischen Feldstärke $H_1$ |
| $\omega_{osc\chi}$ | Frequenz des Oszillators bei Einfluss durch Probenmagnetisierung |
| $\omega_L$ | Lamorfrequenz |
| $\omega_{LC}$ | Resonanzfrequenz des Schwingkreises |
| $\omega_i$ | Frequenz der spektralen Komponenten der Probenmagnetisierung |
| $\chi_m$ | Suszeptibilität |
| CMOS | Complementary metal-oxide-semiconductor (sich ergänzender Metall-Oxid-Halbleiter) |
| ESR | Elektronenspinresenonanz-Spektroskopie |
| NMR | Kernspinresonanzspektroskopie |
| VCO | Voltage Controlled Oscillator, spannungsgesteuerter Oszillator |

## Patentansprüche

1. Vorrichtung zur Erzeugung und Detektion einer transienten Magnetisierung einer Probe (104), aufweisend Mittel (102) zur Bereitstellung eines statischen Magnetfelds (101, 405) vorbestimmter Richtung und Stärke an einem Probenort zur Anordnung der Probe (104), eine Sendevorrichtung zur Bereitstellung eines zusätzlichen Magnetfeldes am Probenort und eine Empfangsvorrichtung zur Detektion einer Magnetisierung der Probe (104) am Probenort, wobei

   • das zusätzliche Magnetfeld ein transientes Magnetfeld ist und die Empfangsvorrichtung zur Detektion einer transienten Magnetisierung der Probe eingerichtet ist und wobei
   • ein LC-Oszillator (103, 601) sowohl die Sendevorrichtung als auch die Empfangsvorrichtung bildet und die Oszillationsfrequenz des LC-Oszillators (103, 601) vom Wert eines induktiven Elements des LC-Oszillators (103, 601) abhängt und wobei die Vorrichtung außerdem Mittel zur Ansteuerung (106) des LC-Oszillators (103, 601) enthält, wobei als Mittel zur Ansteuerung (106) Mittel zur Erzeugung erster und zweiter zeitabhängiger Wellenformen, als Steuerspannung zur Einstellung der Frequenzen von Oszillationen des LC-Oszillators bzw. zur Einstellung der Amplitude der Oszillationen des LC-Oszillators, dienen und wobei ein durch den LC-Oszillator erzeugtes transientes Magnetfeld eine Magnetisierung einer Probe aus einer Gleichgewichtslage auszulenken vermag und die Zeitspanne des transienten Magnetfeld dabei auf den Sub-Nanosekundenbereich, d.h. < 1 ns, beschränkbar ist und der Probenort im Nahfeld, in dem noch keine Welle vorliegt, des LC-Oszillators (103, 601) liegt, wobei
   • dem LC-Oszillator (103, 601) zur Verarbeitung einer Ausgangspannung ein Mittel zur Demodulation (111, 113) und Analog-Digital-Wandler (112, 114) und anschließend Mittel zur digitalen Datenverarbeitung (106) nachgeschaltet sind,
   • Mittel eingerichtet zur Bestimmung spektraler Komponenten der Magnetisierung der Probe auf Grundlage eines physikalischen Modells transienter Induktivität und transienten Widerstands einer Spule anhand mindestens der Frequenz oder Amplitude der Ausgangsspannung des LC-Oszillators (103, 106) in dem Mittel zur digitalen Datenverarbeitung (106) bereitgestellt sind,
   und wobei die Vorrichtung
   • Mittel zur Ausgabe der spektralen Komponenten enthält.

2. Vorrichtung nach Anspruch 1,
   wobei das
   das Mittel zur Demodulation (111, 113) ein Frequenzdemodulator ist und das physikalische Modell von der Gleichung

$$\Delta L_{\text{sample}}(t) \equiv \int_{V_s} [-\vec{B}_1(\vec{r}) \cdot \frac{\vec{M}(t,\vec{r})}{i^2(t)}] dV$$

Gebrauch macht

mit $\Delta L_{\text{sample}}(t)$ = detektierbare Induktivität der Probe im transienten Magnetfeld,
$V_s$ = Probenvolumen, $\vec{B}_1$ = anregendes Magnetfeld, $\vec{r}$ = Abstandsvektor vom Ursprung für die Integration über das Volumen, $\vec{M}$ = Magnetisierung der Probe,
$i(t)$ = zum Spannungsverlust über eine Spule gehöriger Stromfluss und $t$ = Zeit.

3. Vorrichtung nach Anspruch 1,
wobei das
das Mittel zur Demodulation (111, 113) ein Amplitudendemodulator ist und das physikalische Modell von der Gleichung

$$A_{osc} = A_{osc} \big|_{R_{eff}=R_0} + \frac{\partial A_{osc}}{\partial R_{eff}} \big|_{R_{eff}=R_0} \cdot R_{sample,tot}$$

Gebrauch macht

mit $A_{osc}$ = Oszillationsamplitude des LC-Oszillators, $R_{eff}$ = effektiver Widerstand der Spule, $R_0$ = ohmscher Spulenwiderstand und $R_{sample,tot}$ = durch die Probe induzierter Widerstand der Spule.

4. Vorrichtung nach den Ansprüchen 1 bis 3,
wobei
das Mittel zur Demodulation (111, 113) einen Frequenzdemodulator und einen Amplitudendemodulator umfasst und physikalische Modell von Gleichungen

$$\Delta L_{\text{sample}}(t) \equiv \int_{V_s} [-\vec{B}_1(\vec{r}) \cdot \frac{\vec{M}(t,\vec{r})}{i^2(t)}] dV$$

und

$$A_{osc} = A_{osc} \big|_{R_{eff}=R_0} + \frac{\partial A_{osc}}{\partial R_{eff}} \big|_{R_{eff}=R_0} \cdot R_{sample,tot}$$

Gebrauch macht.

5. Vorrichtung nach einem der vorhergehenden Ansprüche,
wobei das
Mittel zur Ansteuerung des LC-Oszillators (103, 601) eine Datenverarbeitungsanlage (106) ist, , wobei Digital-Analog-Wandler (107, 110) dem LC-Oszillator (103, 601) vorgeschaltet sind.

6. Vorrichtung nach Anspruch 5,
wobei der
Digital-Analog-Wandler (107, 110) für die zweite zeitabhängige Wellenform in die Stromquelle des LC-Oszillators (103, 601) integriert ist.

7. Vorrichtung nach einem der vorhergehenden Ansprüche,
wobei der
LC-Oszillator (103, 601) ein LC-VCO (1401) ist.

**8.** Vorrichtung nach Anspruch 7,
wobei die
Schaltungsanordnung des LC-VCO (1401) mindestens eine differentielle Kapazitätsdiode (202) und eine differentielle Induktivität (204) zur Bildung eines LC-Schwingkreises, zwei kreuzgekoppelte Transistoren (201), einen Eingang für die Steuerspannung (203), einen zweiten Eingang für die Versorgungsspannung (207), eine Erdung und zwei Knotenpunkte (205, 206), an denen Ausgangsspannungen abgreifbar sind, aufweist.

**9.** Vorrichtung nach Anspruch 8,
wobei der
LC-VCO erweitert ist durch eine spannungsgesteuerte Stromquelle (708).

**10.** Vorrichtung nach Anspruch 9,
wobei die
spannungsgesteuerte Stromquelle ausgeführt ist als digitale Stromsteuereinrichtung (808).

**11.** Vorrichtung nach mindestens einem der Ansprüche 7 bis 10,
wobei der
LC-VCO (1401) in einen Phasenregelkreis mit zwei Referenzoszillatoren (1405, 1406) eingebunden ist.

**12.** Vorrichtung nach einem der Ansprüche 1 bis 11,
wobei ein
Abwärtsmischer mit Quadraturpfaden (602, 603) zur Verarbeitung der Ausgangsspannung des LC-Oszillators (103, 601) diesem nachgeschaltet ist.

**13.** Verfahren zur Erzeugung und Detektion einer transienten Magnetisierung einer Probe, aufweisend die Schritte:

a. Anordnen der Probe an einem Probenort,
b. Bereitstellen eines statischen Magnetfelds vorbestimmter Richtung und Stärke am Probenort,
c. Erzeugen eines transienten Magnetfelds mit einem LC-Oszillator, dessen Oszillationsfrequenz vom Wert eines induktiven Elements des LC-Oszillators abhängt, wobei

• der Probenort im Nahfeld, in dem noch keine Welle vorliegt, des LC-Oszillators liegt,
• das transiente Magnetfelds genügt, eine Magnetisierung der Probe aus einer Gleichgewichtslage auszulenken und
• die Zeitspanne des transienten Magnetfeldes dabei auf den Sub-Nanosekundenbereich, d.h. < 1 ns, beschränkt ist,

d. Abgreifen einer Ausgangspannung des LC-Oszillators vor, während und in der Folge des transienten Magnetfeldes,
e. Demodulation der zeitabhängigen Änderungen der Frequenz und Amplitude der Ausgangsspannung und Digitalisierung der Ausgangsspannung in vorgegebener Reihenfolge und Übermittlung an Mittel zur digitalen Datenverarbeitung,
f. Eingabe detektierter Frequenzen oder Amplituden in ein physikalisches Modell transienter Induktivität und transienten Widerstands einer Spule, demgemäß
aus einer Frequenz der Oszillatorausgangsspannung mit

$$\Delta L_{\text{sample}}(t) \equiv \int_{V_s} [-\vec{B}_1(\vec{r}) \cdot \frac{\vec{M}(t,\vec{r})}{i^2(t)}] \mathrm{d}V$$

wobei $\Delta L_{\text{sample}}(t)$ = detektierbare Induktivitat der Probe im transienten Magnetfeld, $V_s$ = Probenvolumen, $\vec{B}_1$ = anregendes Magnetfeld,
$\vec{r}$ = Abstandsvektor vom Ursprung für die Integration über das Volumen, $\vec{M}$ = Magnetisierung der Probe, $i(t)$ = zum Spannungsverlust über eine Spule gehöriger Stromfluss und $t$ = Zeit spektrale Komponenten der Probe ermittelt werden,

oder demgemäß
aus einer Amplitude der Oszillatorausgangsspannung $A_{osc}$,

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

mit $R_{eff}$ = effektiver Widerstand der Spule, $R_0$ = ohmscher Spulenwiderstand und $R_{sample,tot}$ = durch die Probe induzierter Widerstand der Spule spektrale Komponenten der Probe ermittelt werden
und
g. Ausgabe der spektralen Komponenten zur Weiterverarbeitung.

**Claims**

1. A device for the generation and detection of a transient magnetisation of a sample (104), having means (102) for the provision of a static magnetic field (101, 405) of a predetermined direction and strength at a sample location for the arrangement of the sample (104), a transmitting device for the provision of an additional magnetic field at the sample location, and a receiving device for the detection of a magnetisation of the sample (104) at the sample location, wherein

    • the additional magnetic field is a transient magnetic field, and the receiving device is equipped for the detection of a transient magnetisation of the sample, and wherein
    • an LC-oscillator (103, 601) forms both the transmitting device and also the receiving device, and the oscillation frequency of the LC-oscillator (103, 601) is a function of the value of an inductive element of the LC-oscillator (103, 601). and wherein
    the device also contains means for driving (106) the LC-oscillator (103, 601), wherein
    means for generating first and second time-dependent waveforms serve as the means for driving (106), as a control voltage for the adjustment of the frequencies of oscillations of the LC-oscillator, or for the adjustment of the amplitude of the oscillations of the LC-oscillator, and wherein
    a transient magnetic field generated by the LC-oscillator is capable of deflecting a magnetisation of a sample from an equilibrium position, and the time span of the transient magnetic field can thereby be limited to the sub-nanosecond range, i.e. < 1 ns, and the sample location is located in the near field of the LC-oscillator (103, 601), in which no wave is yet present, wherein
    • for purposes of processing an output voltage a means for demodulation (111, 113), and analogue-to-digital converters (112, 114), and subsequently means for digital data processing (106), are mounted downstream of the LC-oscillator (103, 601),
    • means equipped for the determination of spectral components of the magnetisation of the sample, based on a physical model of transient inductance and transient resistance of a coil, from at least the frequency or amplitude of the output voltage of the LC-oscillator (103, 106), are provided in the means for digital data processing (106), and wherein the device
    • contains means for outputting the spectral components.

2. The device in accordance with claim 1, wherein the demodulation means (111, 113) is a frequency demodulator, and the physical model uses the equation:

$$\Delta L_{\text{sample}}(t) \equiv \int_{V_s}\left[-\vec{B}_1(\vec{r}) \cdot \frac{\vec{M}(t,\vec{r})}{i^2(t)}\right]dV$$

Where $\Delta L_{\text{sample}}(t)$ = detectable inductance of the sample in the transient magnetic field, $V_s$ = sample volume, $\vec{B}_1$ = exciting magnetic field, $\vec{r}$ = distance vector from the origin for integration over the volume, $\vec{M}$ = magnetisation of the sample, $i(t)$ = the current flow associated with the voltage loss across a coil and $t$ : = time.

3. The device in accordance with claim 1,
wherein

the demodulation means (111, 113) is an amplitude demodulator, and the physical model uses the equation:

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

Where $A_{osc}$ = oscillation amplitude of the LC-oscillator, $R_{eff}$ = effective resistance of the coil, $R_0$ = ohmic coil resistance and $R_{sample,tot}$ = resistance of the coil induced by the sample.

4. The device in accordance with one of the claims 1 to 3, wherein the demodulation means (111, 113) comprises a frequency demodulator and an amplitude demodulator, and the physical model makes use of the equations:

$$\Delta L_{\text{sample}}(t) \equiv \int_{V_s}[-\vec{B}_1(\vec{r}) \cdot \frac{\vec{M}(t,\vec{r})}{i^2(t)}]dV$$

and

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

5. The device in accordance with one of the preceding claims, wherein the means for driving the LC-oscillator (103, 601) is a data processing system (106), wherein digital-to-analogue converters (107, 110) are mounted upstream of the LC-oscillator (103, 601).

6. The device in accordance with claim 5, wherein the digital-to-analogue converter (107, 110) for the second time-dependent waveform is integrated into the current source of the LC-oscillator (103, 601).

7. The device in accordance with one of the preceding claims, wherein the LC-oscillator (103, 601) is an LC-VCO (1401).

8. The device in accordance with claim 7, wherein the circuit arrangement of the LC-VCO (1401) has at least one differential capacitance diode (202) and a differential inductance (204) so as to form an LC-oscillating circuit, two cross-coupled transistors (201), an input for the control voltage (203), a second input for the supply voltage (207), an earth, and two nodes (205, 206) at which output voltages can be tapped off.

9. The device in accordance with claim 8, wherein the LC-VCO is expanded in terms of a voltage-controlled current source (708).

10. The device in accordance with claim 9, wherein the voltage-controlled current source is embodied as a digital current control device (808).

11. The device in accordance with one of the claims 7 to 10, wherein the LC-VCO (1401) is integrated into a phase-locked loop with two reference oscillators (1405, 1406).

12. The device in accordance with one of the claims 1 to 11, wherein a down mixer with quadrature paths (602, 603) for purposes of processing the output voltage of the LC-oscillator (103, 601) is mounted downstream of the latter.

13. A method for the generation and detection of a transient magnetisation of a sample, having the steps:

a. arrangement of the sample at a sample location,

b. provision of a static magnetic field of a predetermined direction and strength at the sample location,
c. generation of a transient magnetic field with an LC-oscillator, whose oscillation frequency depends on the value of an inductive element of the LC-oscillator, wherein

• the sample location is in the near field of the LC-oscillator, where no wave is yet present,
• the transient magnetic field is sufficient to deflect a magnetisation of the sample from an equilibrium position, and
• the time span of the transient magnetic field is limited to the sub-nanosecond range, i.e. < 1 ns,

d. tapping off an output voltage of the LC-oscillator before, during and after the transient magnetic field,
e. demodulation of the time-dependent changes in the frequency and amplitude of the output voltage, and digitisation of the output voltage in a predetermined sequence, and transmission to means for digital data processing,
f. input of detected frequencies or amplitudes into a physical model of transient inductance and transient resistance of a coil,
accordingly,
from a frequency of the oscillator output voltage with

$$\Delta L_{\text{sample}}(t) \equiv \int_{V_s} [-\vec{B}_1(\vec{r}) \cdot \frac{\overrightarrow{M}(t,\vec{r})}{i^2(t)}]\mathrm{d}V$$

where

$\Delta L_{\text{sample}}(t)$ = detectable inductance of the sample in the transient magnetic field,
$V_s$ = sample volume, $\vec{B}_1$ = exciting magnetic field, $\vec{r}$ : = distance vector from the origin for integration over volume, $\overrightarrow{M}$ = magnetisation of the sample, $i(t)$ = the current flow associated with the voltage loss across a coil and $t$ = time spectral components of the sample can be determined,

or accordingly,
from an amplitude of the oscillator output voltage $A_{osc}$,

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

Where $R_{eff}$ = effective resistance of the coil, $R_0$ = ohmic coil resistance and $R_{sample,tot}$ = resistance of the coil induced by the sample spectral components of the sample are determined and
g. output of the spectral components for purposes of further processing.

## Revendications

**1.** Dispositif de production et de détection d'une aimantation transitoire d'un échantillon (104) comportant un moyen (102) pour fournir un champ magnétique statique (101, 405) d'une direction et d'une intensité prédéfinies à un emplacement d'échantillon pour mise en place de l'échantillon (104), un dispositif d'émission pour fournir un champ magnétique supplémentaire à l'emplacement d'échantillon et un dispositif de réception pour la détection d'une aimantation de l'échantillon (104) à l'emplacement d'échantillon, sachant que

• le champ magnétique supplémentaire est un champ magnétique transitoire et le dispositif de réception est agencé pour la détection d'une aimantation transitoire de l'échantillon, et sachant
• qu'un oscillateur à CL (103, 601) forme aussi bien le dispositif d'émission que le dispositif de réception et que la fréquence d'oscillation de l'oscillateur à CL (103, 601) dépend de la valeur d'un élément inductif de l'oscillateur à CL (103, 601) et sachant que le dispositif contient en outre un moyen de commande (106) de l'oscillateur à CL (103, 601), sachant que des moyens de production de la première et deuxième forme d'onde dépendant du temps servent de moyens de commande (106), de tension de commande pour régler les fréquences des oscillations de l'oscillateur à CL ou pour régler l'amplitude des oscillations de l'oscillateur à CL et sachant qu'un champ magnétique transitoire produit par l'oscillateur à CL est capable de dévier une aimantation d'un échantillon à partir d'une situation d'équilibre et la période de temps du champ magnétique transitoire peut être limitée à cet effet à la gamme de sous-nanosecondes, c'est-à-dire < 1 ns, et que l'emplacement d'échantillon se situe dans un champ proche de l'oscillateur à CL (103, 601), dans lequel il n'y pas encore d'onde, sachant

• qu'un moyen de démodulation (111, 113) et un convertisseur analogique-numérique (112, 114) et ensuite un moyen de traitement numérique des données (106) sont connectés en aval de l'oscillateur à CL (103, 601) pour le traitement d'une tension initiale, sachant

• que des moyens agencés pour déterminer des composantes spectrales de l'aimantation de l'échantillon sont fournis sur la base d'un modèle physique d'inductivité transitoire et de résistance transitoire d'une bobine à l'aide d'au moins la fréquence ou l'amplitude de la tension initiale de l'oscillateur à CL (103, 601) dans le moyen de traitement numérique des données (106) et sachant que le dispositif

• contient des moyens d'éditer les composantes spectrales.

2. Dispositif selon la revendication 1,
sachant que le moyen de démodulation (111, 113) est un démodulateur de fréquence et que le modèle physique fait usage de l'équation

$$\Delta L_{\text{sample}}(t) \equiv \int_{V_s} [-\vec{B}_1(\vec{r}) \cdot \frac{\vec{M}(t,\vec{r})}{i^2(t)}] \mathrm{d}V$$

dans laquelle $\Delta L_{\text{sample}}(t)$ est l'inductivité détectable de l'échantillon dans le champ magnétique transitoire, $V_s$ est le volume d'échantillon, $\vec{B}_1$ le champ magnétique d'excitation, $\vec{r}$ est le vecteur de distance de l'origine pour l'intégration par le volume, $\vec{M}$ est l'aimantation de l'échantillon, $i(t)$ pour la perte de tension par un flux de courant appartenant à une bobine et $t$ : est le temps.

3. Dispositif selon la revendication 1,
sachant que
le moyen de démodulation (111, 113) est un démodulateur d'amplitude et que le modèle physique fait usage de l'équation

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

dans laquelle $A_{osc}$ est l'amplitude d'oscillation de l'oscillateur à CL, $R_{eff}$: la résistance effective de la bobine, $R_0$ la résistance de bobine ohmique et $R_{sample,tot}$ la résistance de la bobine induite par l'échantillon.

4. Dispositif selon les revendications 1 à 3, sachant que
le moyen de démodulation (111, 113) comprend un démodulateur de fréquence et un démodulateur d'amplitude et le modèle physique fait usage des équations

$$\Delta L_{\text{sample}}(t) \equiv \int_{V_s} [-\vec{B}_1(\vec{r}) \cdot \frac{\vec{M}(t,\vec{r})}{i^2(t)}] \mathrm{d}V$$

et

$$A_{osc} = A_{osc}\big|_{R_{eff}=R_0} + \frac{\partial A_{osc}}{\partial R_{eff}}\big|_{R_{eff}=R_0} \cdot R_{sample,tot}$$

**5.** Dispositif selon l'une quelconque des revendications précédentes, sachant que
le moyen de commande de l'oscillateur à CL (103, 601) est une installation de traitement des données (106), sachant que des convertisseurs numériques-analogiques (107, 110) sont connectés en amont de l'oscillateur à CL (103, 601).

**6.** Dispositif selon la revendication 5, sachant que
le convertisseur numérique-analogique (107, 110) est intégré pour la deuxième forme d'onde en fonction du temps dans la source de courant de l'oscillateur à CL (103, 601).

**7.** Dispositif selon l'une quelconque des revendications précédentes, sachant que
l'oscillateur à CL (103, 601) est un oscillateur commandé en tension à cristaux liquides (OCT-CL) (1401).

**8.** Dispositif selon la revendication 7, sachant que
le système de connexion de l'OCT-CL (1401) comporte au moins une diode de capacité différentielle (202)et une inductivité différentielle (204) pour la formation d'un circuit oscillant à CL, deux transistors à couplage croisé (201), une entrée pour la tension de commande (203), une deuxième entrée pour la tension d'alimentation (207) une mise à la terre et deux points nodaux (205, 206) sur lesquels des tensions initiales peuvent être prélevées.

**9.** Dispositif selon la revendication 8, sachant que
l'OCT-CL est étendu par une source de courant asservie en tension (708).

**10.** Dispositif selon la revendication 9, sachant que
la source de courant asservie en tension est exécutée sous la forme d'un dispositif de commande de courant numérique (808).

**11.** Dispositif selon au moins l'une quelconque des revendications 7 à 10, sachant que
l'OCT-CL (1401) est intégré dans un circuit à régulation de phase avec deux oscillateurs de référence (1405, 1406).

**12.** Dispositif selon l'une quelconque des revendications 1 à 11,
sachant qu'un convertisseur réducteur avec des pistes de quadrature (602, 603) pour le traitement de la tension initiale de l'oscillateur à CL (103, 601) est connecté en aval de celui-ci.

**13.** Procédé de production et de détection d'une aimantation transitoire d'un échantillon, comportant les étapes de :

a. mise en place de l'échantillon sur un emplacement d'échantillon,
b. fourniture d'un champ magnétique statique d'une direction et d'une intensité prédéfinies à l'emplacement d'échantillon,
c. production d'un champ magnétique transitoire avec un oscillateur à CL, dont la fréquence d'oscillation dépend d'une valeur d'un élément inductif de l'oscillateur à CL, sachant que

• l'emplacement d'échantillon se situe dans un champ proche de l'oscillateur à CL dans lequel il n'y a pas encore d'onde,
• le champ magnétique transitoire est suffisant pour dévier une aimantation de l'échantillon à partir d'une situation d'équilibre, et
• la période de temps du champ magnétique transitoire peut être limitée à cet effet à une gamme de sous-nanosecondes, c'est-à-dire < 1 ns,

d. prélèvement d'une tension initiale de l'oscillateur à CL avant, pendant et à la suite du champ magnétique transitoire,

e. démodulation des variations en fonction du temps de la fréquence et de l'amplitude de la tension initiale et numérisation de la tension initiale dans une ordre prédéfini et transmission à des moyens pour traitement numérique des données,

f. introduction des fréquences ou amplitudes détectées dans un modèle physique d'inductivité transitoire et de résistance transitoire d'une bobine,

par conséquence

à partir d'une fréquence de la tension initiale d'oscillateur avec

$$\Delta L_{\text{sample}}(t) \equiv \int_{V_s} [-\vec{B}_1(\vec{r}) \cdot \frac{\overrightarrow{M}(t,\vec{r})}{i^2(t)}] dV$$

sachant que les composantes spectrales de l'échantillon, $\Delta L_{\text{sample}}(t)$ inductivité détectable de l'échantillon dans le champ magnétique transitoire, $V_s$ volume d'échantillon, $\vec{B}_1$ champ magnétique d'excitation, $\vec{r}$ : vecteur de distance de l'origine pour l'intégration par le volume, $\overrightarrow{M}$ aimantation de l'échantillon, pour la perte de tension par un flux de courant appartenant à ne bobine et $t$: le temps, sont déterminés,

ou en conséquence

les composantes spectrales de l'échantillon sont déterminées à partir d'une amplitude de la tension initiale de l'oscillateur $A_{osc}$,

$$A_{osc} = A_{osc}\big|_{R_{eff}=R_0} + \frac{\partial A_{osc}}{\partial R_{eff}}\big|_{R_{eff}=R_0} \cdot R_{sample,tot}$$

dans laquelle $R_{eff}$ la résistance effective de la bobine, $R_0$ la résistance de bobine ohmique et Rsample, tot la résistance de la bobine induite par l'échantillon

et

g. édition des composantes spectrales pour traitement ultérieur.

Fig. 1

Fig. 2

Fig. 3

Fig. 4

Fig. 5

EP 3 380 857 B1

Fig. 6

34

Fig. 7

205    204    206

202    203    201

707    708

Fig. 8

205    204    206

202    203    201

808

707

Fig. 9

a)

b)

Fig. 10

Fig. 11

Fig. 12

Fig. 13

Fig. 14

a)

b)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4223909 C2
- DE 4412064 A1
- US 20140210473 A1
- WO 2005073695 A1
- US 20140091802 A1
- US 20140097842 A1

**In der Beschreibung aufgeführte Nicht-Patentliteratur**

- **M. PRISNER et al.** Pulsed EPR Spectroscopy: Biological Applications. *Annual Review of Physical Chemistry,* 2001, vol. 52, 279-313
- **R. BENN ; H. GÜNTHER.** Modern Pulse Methods in High-Resolution NMR Spectroscopy. *Angewandte Chemie International Edition,* 1983, vol. 22, 350-380
- **T. YALCIN ; G. BOERO.** Single-chip detector for electron spin resonance spectroscopy. *Review of Scientific Instruments,* 2008, vol. 79, 094105-1, 6
- **N. BLOEMBERGEN ; R.V. POUND.** Radiation Damping in Magnetic Resonance Experiments. *Physical Reviews,* 1954, vol. 95 (1), 8-12
- **P. KINGET.** Amplitude detection inside CMOS LC oscillators. *2006 IEEE International Symposium on Circuits and Systems, Vol. 1-11, Proceedings 2006,* 2006, vol. 1-11, 5147-5150